# EUROPEAN PATENT APPLICATION

(11) **EP 4 766 132 A1**
(43) Date of publication of application: **24.06.2026**
(21) Application number: 25206686.5
(22) Date of filing: 03.10.2025
(51) Int. Cl.: H10W 20/00, H10W 20/40, H10D 84/01, H10W 20/41

(54) **SEMICONDUCTOR DEVICE**

(30) Priority: 20.12.2024 KR 20240193163
(71) Applicant: Samsung Electronics Co., Ltd., Suwon-si, Gyeonggi-do 16677 (KR)
(72) Inventor: YANG, Youngjin, Suwon-si (KR); KIM, Hongshin, Suwon-si (KR); YANG, Nakyoung, Suwon-si (KR)
(74) Representative: Marks & Clerk LLP

(57) **Abstract**

A semiconductor device includes a base insulating pattern, a partition wall positioned on the base insulating pattern, a first channel structure and a second channel structure positioned apart from each other with the partition wall therebetween, a gate structure surrounding the first channel structure and the second channel structure, first source/drain patterns connected to opposite sides of the first channel structure, second source/drain patterns connected to opposite sides of the second channel structure and spaced apart from the first source/drain patterns with the partition wall between the first source/drain patterns and the second source/drain patterns, and a lower contact electrode structure connected to lower portions of the first source/drain patterns and the second source/drain patterns. The partition wall extends in a direction toward a lower surface of the base insulating pattern and the partition wall extends through the lower contact electrode structure.

## Description

### BACKGROUND

### 1. Field

The present disclosure relates to a semiconductor device.

### 2. Description of the Related Art

A semiconductor is a material belonging to an intermediate region between a conductor and an insulator, and refers to a material that conducts electricity under a predetermined condition. Various semiconductor devices can be manufactured by using such a semiconductor material, and for example, a memory device and the like can be manufactured. Such a semiconductor device may be used in various electronic devices.

As the electronics industry develops, demands on characteristics of semiconductor devices are increasing. For example, there is an increasing demand for high reliability, high speed, and/or multi-functionality in semiconductor devices. To meet these demanded characteristics, structures within semiconductor devices are becoming increasingly complex and integrated. As a size of transistors decreases, coupling may occur between elements, which may reduce an operating speed of semiconductor device and deteriorate reliability of the semiconductor device.

Recently, research is being conducted to improve routing congestion and scale a size of semiconductor devices by positioning a power delivery network (PDN) for routing signals provided to the semiconductor devices on a back surface of a substrate.

### SUMMARY

The embodiments attempt to provide a semiconductor device capable of improving reliability.

An embodiment of the present disclosure provides a semiconductor device comprising a base insulating pattern; a partition wall positioned on the base insulating pattern; a first channel structure and a second channel structure positioned apart from each other with the partition wall therebetween; a gate structure surrounding the first channel structure and the second channel structure; first source/drain patterns connected to opposite sides of the first channel structure; second source/drain patterns connected to opposite sides of the second channel structure and spaced apart from the first source/drain patterns with the partition wall between the first source/drain patterns and the second source/drain patterns; and a lower contact electrode structure connected to lower portions of the first source/drain patterns and the second source/drain patterns, wherein the partition wall extends in a direction toward a lower surface of the base insulating pattern and the partition wall extends through the lower contact electrode structure.

An embodiment of the present disclosure provides a semiconductor device comprising a base insulating pattern; a partition wall positioned on the base insulating pattern; a first channel structure and a second channel structure positioned apart from each other with the partition wall therebetween; a gate structure surrounding the first channel structure and the second channel structure; first source/drain patterns connected to opposite sides of the first channel structure; second source/drain patterns connected to opposite sides of the second channel structure and spaced apart from the first source/drain patterns with the partition wall between the first source/drain patterns and the second source/drain patterns; a lower contact electrode structure connected to lower portions of the first source/drain patterns and the second source/drain patterns; a power rail positioned below the base insulating pattern; a device isolation layer positioned at a first side of the first source/drain pattern or the second source/drain pattern; and one or more connection wires positioned within the device isolation layer and spaced apart from the power rail.

An embodiment of the present disclosure provides a semiconductor device comprising a base insulating pattern; a partition wall extending in a first direction parallel to a first surface of the base insulating pattern and comprising a first end extending into an interior of the base insulation pattern; a first channel structure and a second channel structure positioned on the base insulation pattern and spaced apart from each other in a second direction intersecting the first direction with the partition wall between the first channel structure and the second channel structure, the first channel structure and the second channel structure each comprising first side surfaces that are in contact with the partition wall; a gate structure surrounding the first channel structure and the second channel structure; first source/drain patterns connected to opposite sides of the first channel structure; second source/drain patterns connected to opposite sides of the second channel structure and spaced apart from the first source/drain patterns with the partition wall between the first source/drain patterns and the second source/drain patterns; a lower contact electrode structure connected to lower portions of the first source/drain patterns and the second source/drain patterns; a power rail positioned below the base insulating pattern; a first lower insulating pattern positioned between the lower contact electrode structure and the power rail; a lower contact via extending through the first lower insulating pattern in a third direction that is perpendicular to the first direction and the second direction, and have an upper surface in contact with the lower contact electrode structure and a lower surface in contact with an upper surface of the power rail; a device isolation layer positioned at a first side of the first source/drain pattern or the second source/drain pattern and covering a side surface of the base insulation pattern; and one or more connection wires positioned within the device isolation layer and spaced apart from the power rail, wherein the partition wall extends through the lower contact electrode structure and has a lower surface positioned at a level between a level of an upper surface of the power rail and a level of a lower surface of the lower contact electrode structure, the lower contact electrode structure includes a first lower contact electrode connected to one of the first source/drain patterns, and a second lower contact electrode connected to one of the second source/drain patterns, and the connection wire includes a first connection wire connecting the first lower contact electrode and the second lower contact electrode to each other, and a second connection wire connecting at least one of the first source/drain patterns and the second source/drain patterns to the gate structure.

An embodiment of the present disclosure provides a manufacturing method for a semiconductor device, including forming a partition wall that extends in a lower direction of a substrate on the substrate forming a first channel structure and a second channel structure at opposite sides of the partition wall, forming a gate structure surrounding the first channel structure and the second channel structure, forming first source/drain patterns at opposite sides of the first channel structure and forming second source/drain patterns at opposite sides of the second channel structure, and forming a lower contact electrode structure connected to the first source/drain pattern and the second source/drain pattern under the first source/drain pattern and the second source/drain pattern, wherein the forming of the lower contact electrode structure may include positioning the lower surface of the lower contact structure at a level that is higher than that of a lower surface of the partition wall.

In the manufacturing method for a semiconductor device according to an embodiment, the positioning of the lower surface of the lower contact structure at a higher level than that of the lower surface of the partition wall may include removing a substrate positioned under the first source/drain pattern and the second source/drain pattern, forming a base insulating pattern by filling a portion where the substrate has been removed with an insulating material, removing a portion of the base insulating pattern to expose the lower regions of the first source/drain pattern and the second source/drain pattern, filling a portion where the base insulating layer has been removed with a conductive material, and exposing a lower region of the partition wall by etching the conductive material.

In the manufacturing method for a semiconductor device according to an embodiment, the lower contact electrode structure may be separated into a first lower contact electrode and a second lower contact electrode as a lower region of the partition wall is exposed.

The manufacturing method for a semiconductor device according to an embodiment may further include forming a lower insulating layer under the base insulating layer, forming a lower contact via that extends through a portion of the lower insulating layer and has an upper surface connected to a lower surface of the first source/drain pattern or the second source/drain pattern, and forming a power rail in which the lower contact via and a portion of the upper surface contact each other below the base insulating layer.

The manufacturing method for a semiconductor device according to an embodiment may further include forming a device isolation layer positioned at a first side of the first source/drain pattern or the second source/drain pattern, and forming a connection wire positioned apart from the power rail.

In the manufacturing method for a semiconductor device according to an embodiment, the forming of the connection wire may include removing a portion of the base insulating layer, and forming a conductive material at a position where a portion of the base insulation layer has been removed may be included.

The method of manufacturing a semiconductor device according to an embodiment may further include forming a lower insulating pattern positioned between the connection wire and the power rail.

According to the embodiments, it may be possible to provide a semiconductor device capable of improving reliability.

At least some of the above and other features of the invention are set out in the claims.

### BRIEF DESCRIPTION OF THE DRAWINGS

FIG. 1 illustrates a top plan view of a semiconductor device according to an embodiment.
FIG. 2 illustrates a cross-sectional view taken along a line I1-I1' of FIG. 1.
FIG. 3 illustrates a cross-sectional view taken along a line I2-I2' of FIG. 1.
FIG. 4 illustrates a cross-sectional view taken along a line I3-I3' of FIG. 1.
FIG. 5 illustrates a cross-sectional view taken along a line I4-I4' of FIG. 1.
FIG. 6 illustrates a cross-sectional view taken along a line I5-I5' of FIG. 1.
FIG. 7 illustrates a cross-sectional view taken along a line I6-I6' of FIG. 1.
FIG. 8 illustrates a view for describing a semiconductor system according to an embodiment.
FIG. 9 illustrates a view for describing a semiconductor device according to embodiment.
FIG. 10 illustrates a view for describing a semiconductor system according to an embodiment.
FIG. 11 illustrates a view for describing a semiconductor system according to an embodiment.
FIG. 12 to FIG. 62 illustrate process cross-sectional views for describing a manufacturing method for a semiconductor package according to an embodiment.

### DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure.

Further, since sizes and thicknesses of constituent members shown in the accompanying drawings may be arbitrarily given for better understanding and ease of description, the present disclosure is not limited to the illustrated sizes and thicknesses. Like numerals refer to like or similar components throughout the disclosure.

In addition, unless explicitly described to the contrary, the word "comprise" and variations such as "comprises" or "comprising" will be understood to imply the inclusion of stated elements but not the exclusion of any other elements. When a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

Further, throughout the specification, the phrase "in a plan view" refers to a view of an object from above, and the phrase "in a cross-sectional view" refers to a view of a cross-section, which may be a vertical cross section (e.g., as if an object is viewed from the side after vertically cutting the object).

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

As used herein, components described as being "electrically connected" are configured such that an electrical signal can be transferred from one component to the other (although such electrical signal may be attenuated in strength as it is transferred and may be selectively transferred).

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures.

It will be understood that when an element is referred to as being "connected" or "coupled" to or "on" another element, it can be directly connected or coupled to or on the other element or intervening elements may be present. In contrast, when an element is referred to as being "directly connected," "directly attached," "directly joined," or "directly coupled" to another element, or as "contacting" or "in contact with" another element (or using any form of the word "contact"), there are no intervening elements present at the point of contact. Further, in the specification, the word "on" may refer to positioning above, to the side or below an object, and does not necessarily mean positioned on the upper side of the object.

In a drawing of a semiconductor device according to an embodiment, a transistor including nanowires or nanosheets, multi-bridge channel field effect transistor (MBCFET^{™}), a fin-type transistor (FinFET) including a fin-like patterned channel region is illustrated, but the present disclosure is not limited thereto. It may be noted that semiconductor devices according to some embodiments may include tunneling FETs, 3D stack field effect transistors (3DSFETs), complementary field effect transistors (CFETs), and the like.

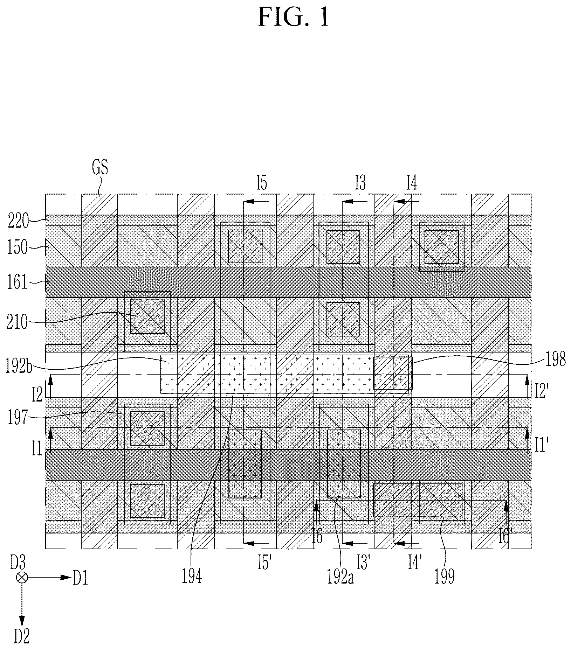

Hereinafter, a semiconductor device according to an embodiment will be described with reference to FIG. 1 to FIG. 6. Specifically, FIG. 1 illustrates a top plan view of a semiconductor device according to an embodiment,

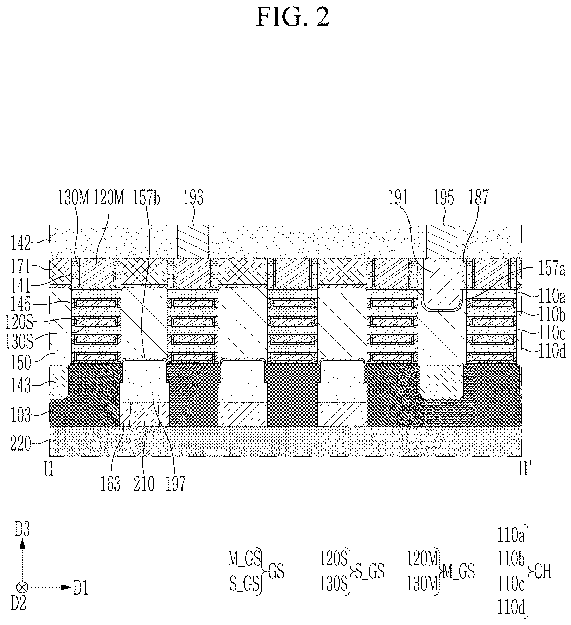

FIG. 2 illustrates a cross-sectional view taken along a line I1-I1' of FIG. 1,

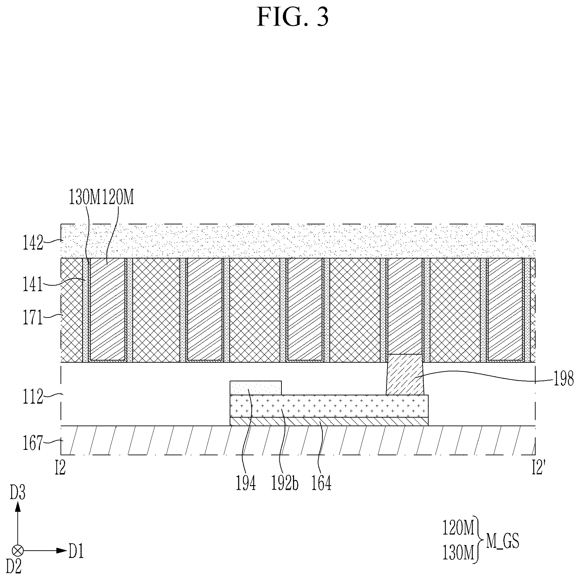

FIG. 3 illustrates a cross-sectional view taken along a line I2-I2' of FIG. 1,

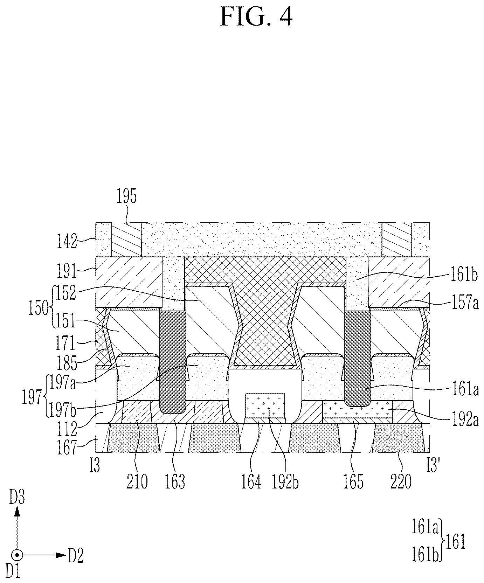

FIG. 4 illustrates a cross-sectional view taken along a line I3-I3' of FIG. 1,

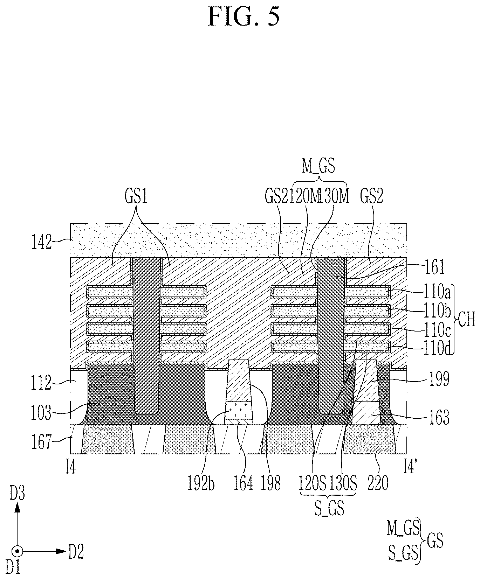

FIG. 5 illustrates a cross-sectional view taken along a line I4-I4' of FIG. 1, and

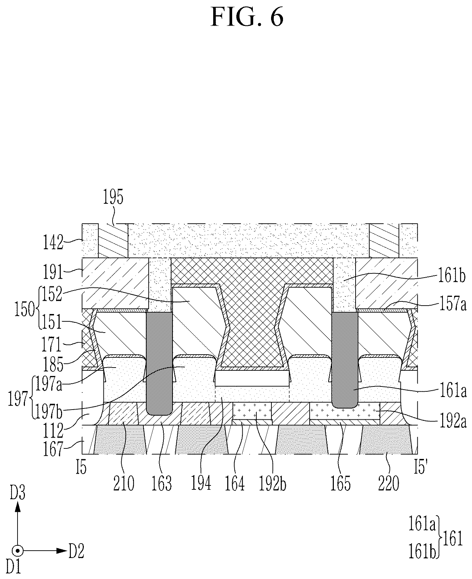

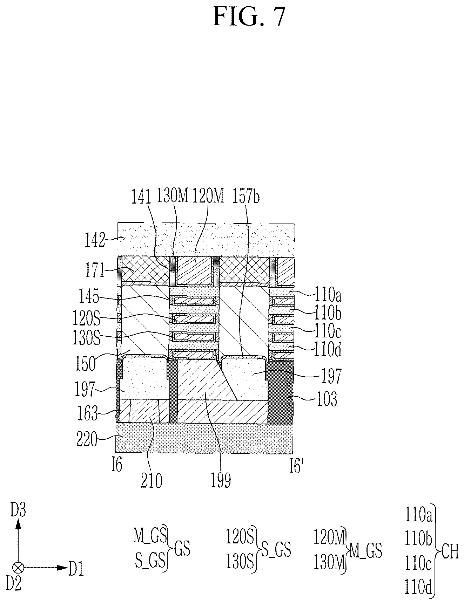

FIG. 6 illustrates a cross-sectional view taken along a line I5-I5' of FIG. 1. FIG. 7 illustrates a cross-sectional view taken along a line I6-I6' of FIG. 1. FIG. 1 illustrates a semiconductor device as having a planar shape according to an embodiment when viewed in a third direction D3 from above or below a base insulating pattern 103.

Referring to FIGS. 1 to 7, a semiconductor device according to an embodiment may include the base insulating pattern 103, a partition wall 161 positioned on the base insulating pattern 103, channel structures CH positioned spaced apart from each other with the partition wall 161 therebetween, a gate structure GS surrounding the channel structures CH, source/drain patterns 151 and 152 connected to opposite sides of each of the channel structures CH, and a contact electrode structure 197 connected to lower portions of the source/drain patterns 151 and 152.

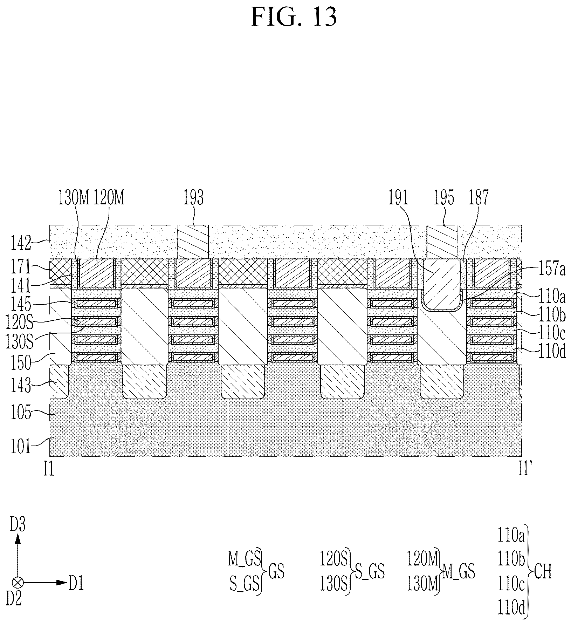

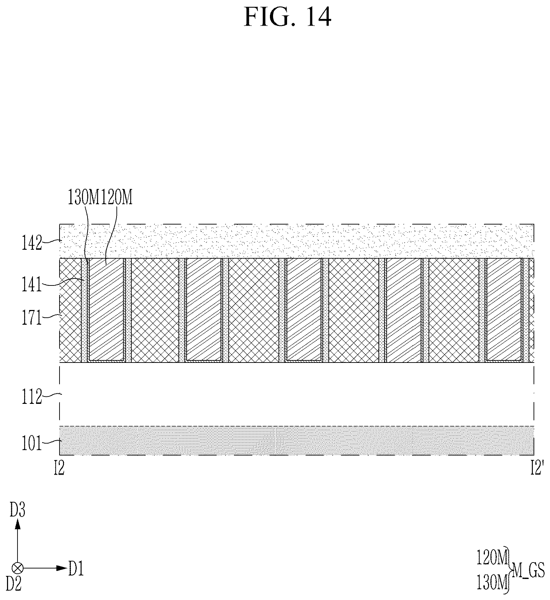

The base insulating pattern 103 may be formed of an insulating material. The base insulating pattern 103 may be formed of an oxide, a nitride, an oxynitride, or a combination thereof. For example, the base insulating pattern 103 may be formed of a silicon oxide SiO₂. The base insulating pattern 103 is illustrated as a single film, but this is merely for better understanding and ease of description, and the present disclosure is not limited thereto. The base insulating pattern 103 may be formed by etching a substrate 101 (see FIG. 14) or a lower pattern 105 (see FIG. 13) described below, and then filling the etched portion with an insulating material.

A first surface and a second surface of the base insulating pattern 103 may be formed as surfaces parallel to a first direction D1 and a second direction D2 intersecting the first direction D1. For example, the first surface of the base insulating pattern 103 may be an upper surface of the base insulating pattern 103 and may be parallel to the first direction D1 and the second direction D2, and the second surface may be a lower surface of the base insulating pattern 103 and may be parallel to the first direction D1 and the second direction D2. The upper surface of the base insulating pattern 103 may be a surface opposite the lower surface of the base insulating pattern 103 in the third direction D3. The third direction D3 may be a direction perpendicular to the first direction D1 and the second direction D2. The lower surface of the base insulating pattern 103 may be referred to as a back side of the base insulating pattern 103. In some embodiments, a logic circuit of a cell region may be implemented on an upper surface of the base insulating pattern 103.

A semiconductor device according to an embodiment may include a plurality of base insulating patterns 103 positioned spaced apart from each other along the second direction D2. The base insulating patterns 103 may be extended in the first direction D1. The base insulating patterns 103 may be positioned apart from each other along the second direction D2. For example, the base insulating patterns 103 may be positioned in a region where a P-channel metal-oxide-semiconductor (PMOS) is to be formed. As another example, the base insulating patterns 103 may be positioned in a region where an N-channel metal-oxide-semiconductor (NMOS) is to be formed. For example, in FIG. 5, the PMOS may be formed in the base insulating pattern 103 positioned on the left, and the NMOS may be formed in the base insulating pattern 103 positioned on the right, but the present disclosure is not limited thereto.

A semiconductor device according to an embodiment may include a device isolation layer 112 positioned between base insulating patterns 103. The device isolation layer 112 may electrically isolate elements that are separated from each other. Specifically, the device isolation layer 112 may be positioned at opposite sides of the base insulating pattern 103 extending in the first direction D1. The device isolation layer 112 may be extended in the first direction D1. A plurality of device isolation layers 112 may be arranged spaced apart from one another in the second direction D2. The device isolation layers 112 and the base isolation patterns 103 may be alternately arranged along the second direction D2.

In an embodiment, a lower surface of the device isolation layer 112 may be positioned at substantially the same level as that of a lower surface of the base insulating pattern 103. An upper surface of the device isolation layer 112 may be positioned at a lower level than that of an upper surface of the base insulating pattern 103. However, the present disclosure is not limited thereto, and the upper surface of the device isolation layer 112 may be positioned at substantially the same level as that of the upper surface of the base insulating pattern 103. The device isolation layer 112 may cover at least a portion of a region on opposite sides of the base insulating pattern 103.

The device isolation layer 112 may be formed of an insulating material. The device isolation layer 112 may be formed of an insulating material that is different from the base insulating pattern 103, but the present disclosure is not limited thereto. The device isolation layer 112 may be formed of, e.g., a silicon oxide (SiO₂), a silicon nitride (SiNₓ), a silicon oxynitride (SION), or combinations thereof. However, the present disclosure is not limited thereto, and the device isolation layer 112 may be formed of various insulating materials. In an embodiment, as described herein, connection wires 192a and 192b may be positioned inside the device isolation layer 112.

The partition wall 161 may be positioned on the base insulating pattern 103. For example, each partition wall 161 may be positioned on a corresponding one of the base insulating patterns 103. The partition wall 161 may extend along the first direction D1. A plurality of partition walls 161 positioned on the respective base insulating patterns 103 may be positioned spaced apart from each other along the second direction D2. As illustrated in FIG. 5, one partition wall of the plurality of partition walls 161 may be positioned on one base insulating pattern of the base insulating patterns 103, while another partition wall of the plurality of partition walls 161 may be positioned on a different base insulating pattern of the base insulating patterns 103, with the two partition walls 161 spaced apart from each other along the second direction D2.

The partition wall 161 may be positioned between side surfaces of the base insulating pattern 103. The partition wall 161 may include a region overlapping the base insulating patterns 103 in the second direction D2. The partition wall 161 may have a lower portion surrounded by the base insulating pattern 103. Referring to FIG. 5, the partition wall 161 may extend through the upper surface of the base insulating pattern 103 and extend toward the lower surface of the base insulating pattern 103. At least a portion of the lower and side surfaces of the partition wall 161 positioned at a level that is equal to or lower than a level at which the upper surface of the base insulating pattern 103 is positioned may be surrounded by the base insulating pattern 103. The base insulating pattern 103 may therefore surround the lower portion of the partition wall 161, with the lower portion of the partition wall 161 extending partially, but not completely, through the base insulating pattern 103 in the third direction D3.

The partition wall 161 may be positioned between side surfaces of the channel structures CH, gate structures GS, and source/drain patterns 150 to be described later. The channel structures CH, the gate structures GS, and the source/drain patterns 150 positioned on the base insulating pattern 103 may be positioned spaced apart from each other with the partition wall 161 therebetween. Specifically, two channel structures CH may be positioned spaced apart from each other along the second direction D2 with one partition wall 161 extending along the first direction D1 provided therebetween, such that the one partition wall 161 may separate (e.g., and may be positioned between) a first channel structure CH and a second channel structure CH (e.g., as illustrated in FIG. 5). Two gate structures GS may be positioned spaced apart from each other along the second direction D2 with one partition wall 161 extending along the first direction D1 provided therebetween, such that the one partition wall 161 may separate (e.g., and may be positioned between) a first gate structure GS and a second gate structure GS (e.g., as illustrated in FIG. 5). Two source/drain patterns 150 may be positioned spaced apart from each other along the second direction D2 with one partition wall 161 extending along the first direction D1 provided therebetween, such that the one partition wall 161 may separate (e.g., and may be positioned between) a first source/drain pattern 150 and a second source/drain pattern 150 (e.g., as illustrated in FIGS. 4 and 6). Specifically, when viewed in cross-sectional views (e.g., FIG. 4, FIG. 5, and FIG. 6), two transistor structures, each including a respective channel structure CH, a respective gate structure GS, and a respective source/drain pattern 150, may be positioned spaced apart from each other with one partition wall 161 provided therebetween on one base insulating pattern 103.

The upper surface of the partition wall 161 may be in contact with the lower surface of a capping layer 142 to be described later. An upper surface of the partition wall 161 may be positioned at substantially the same level as that of an upper surface of the gate structure GS to be described later. A lower surface of the partition wall 161 may be positioned between the upper surface and the lower surface of the base insulating pattern 103. As illustrated in FIG. 5, the upper surface of the base insulating pattern 103 may lie within an uppermost plane, wherein the plane is at the top, or uppermost boundary, of the base insulating pattern 103, and the partition wall 161 may extend through the uppermost plane. The lower surface of the base insulating pattern 103 may lie within a lowermost plane, wherein the lowermost plane is at the bottom, or lowermost boundary, of the base insulating pattern 103, and the partition wall 161 may not extend through the lowermost plane. In an embodiment, the lower surface of the partition wall 161 may be positioned between an upper surface of a power rail 220 to be described later and a lower surface of the lower contact electrode structure 197. For example, as illustrated in FIGS. 4 and 6, the upper surface of the power rail 220 may lie within a first plane, and the lower surface of the lower contact electrode structure 197 may lie within a second plane, and the lower surface of the partition wall 161 may be between (e.g., at a level between) the first plane and the second plane.

In an embodiment, the partition wall 161 may include a lower region 161a and an upper region 161b positioned on the lower region 161a. Specifically, referring to FIG. 1, FIG. 4, and FIG. 6, the partition wall 161 may include the lower region 161a and the upper region 161b in a region that borders, or is adjacent to, the source/drain pattern 150 in the second direction D2 (See FIG. 1). The formation of the lower region 161a and the upper region 161b may occur when a portion of the partition wall 161 is etched together with an etching material (etchant, etching gas, etc.) in a process of recessing a portion of the substrate or semiconductor layer to form the source/drain pattern 150.

An upper surface of the lower region 161a may be in contact with a lower surface of the upper region 161b. An interface between the lower region 161a and the upper region 161b may be positioned between the upper and lower surfaces of the source/drain pattern 150. For example, as illustrated in FIGS. 4 and 6, the upper surface of the source/drain pattern 150 may lie within a first plane, and the lower surface of the source/drain pattern 150 may lie within a second plane, and the interface between the lower region 161a and the upper region 161b may be between (e.g., at a level between) the first plane and the second plane. An upper surface of the upper region 161b may be formed integrally with the capping layer 142 (e.g., with the upper region 161b and the capping layer 142 formed at the same time), which will be described later.

The partition wall 161 may be formed of an insulating material. The partition wall 161 may be formed of, for example, a silicon oxide (SiO₂), a silicon nitride (SiNₓ), a silicon oxynitride (SION), or combinations thereof. However, the present disclosure is not limited thereto, and the partition wall 161 may be formed of various insulating materials. In some embodiments, the partition wall 161 may be formed of a low dielectric constant material. The partition wall 161 may be formed of a material having an etching selectivity with respect to the channel structure CH to be described later.

Channel structures CH may be positioned on a first surface of the base insulating pattern 103. The channel structures CH may be arranged spaced apart in the first direction D1 on the base insulating pattern 103. The channel structures (CH) may also be arranged spaced apart in the second direction D2 on the base insulating pattern 103. In an embodiment, the partition wall 161 may be positioned between two channel structures CH arranged spaced apart in the second direction D2. In an embodiment, the partition wall 161 may be positioned between two channel structures CH arranged spaced apart in the second direction D2 and positioned on one base insulating pattern 103. For example, and as illustrated in FIG. 5, a first axis extending in the third direction D3 and perpendicular to an upper surface of the base insulating pattern 103 may pass through a first channel structure CH, a second axis extending in the third direction D3 and parallel to the first axis may pass through a second channel structure CH, and a third axis extending in the third direction D3 and parallel to, and between, the first axis and the second axis may pass through the partition wall 161, with the partition wall 161 extending vertically along the third axis.

Each of the channel structures CH may include a first channel pattern 110a, a second channel pattern 110b, a third channel pattern 110c, and a fourth channel pattern 110d. The channel patterns 110a, 110b, 110c, and 110d may be arranged spaced apart from each other in the third direction D3. For example, each of the channel patterns 110a, 110b, 110c, and 110d may have a sheet shape. Each of the channel patterns 110a, 110b, 110c, and 110d may be a nanosheet having a thickness of several nanometers along the third direction D3, for example, a thickness within a range from 1 nanometer to 20 nanometers.

The channel structures CH may provide a path for current to flow between the source/drain patterns 150, which will be described below. Referring to FIGS. 2 and 3, the channel structure CH may be positioned between the source/drain patterns 150 to connect the source/drain patterns 150. The channel structures CH may extend through a portion of the gate structure GS in a direction (e.g., the first direction D1) that intersects a direction in which the gate structure GS described below extends. In FIGS. 2 and 4, the channel structures CH are illustrated as having four channel patterns 110a, 110b, 110c, and 110d arranged spaced apart in the third direction D3, but the present disclosure is not limited thereto, and a number of stacked channel patterns 110a, 110b, 110c, and 110d included in one channel structure CH may vary.

The channel structures CH may be formed of a semiconductor material. For example, the channel structures CH may be formed of group IV semiconductors such as Si, Ge, group III-V compound semiconductors, group II-VI compound semiconductors, etc. In an embodiment, the base insulating pattern 103 may be positioned below a lower portion of the channel structure CH.

The channel patterns 110a, 110b, 110c, and 110d may each have a side surface that comes into contact with the source/drain pattern 150 described later. Referring to FIG. 2, opposite side surfaces of each of the channel patterns 110a, 110b, 110c, and 110d may come into contact with two source/drain patterns 150 positioned on opposite sides of the channel structure CH, for example, adjacent to opposing side surfaces of the channel structure CH.

The channel patterns 110a, 110b, 110c, and 110d may have some regions in contact with a main gate insulating layer 130M or a sub-gate insulating layer 130S described later. Referring to FIG. 5, upper and lower surfaces of each of the channel patterns 110a, 110b, 110c, and 110d may be in contact with the main gate insulating layer 130M or the sub-gate insulating layer 130S. First side surfaces of the channel patterns 110a, 110b, 110c, and 110d may be in contact with the main gate insulating layer 130M. In an embodiment, second side surfaces of the channel patterns 110a, 110b, 110c, and 110d may be in contact with the side surface of the partition wall 161.

In an embodiment, the channel structures CH respectively positioned on two different base insulating patterns 103 spaced apart from each other in the second direction D2 may include different types of semiconductor materials. For example, in FIG. 5, the two channel structures CH positioned on the base insulating pattern 103 positioned on the left may include a P-type semiconductor material, and the two channel structures CH positioned on the base insulating pattern 103 positioned on the right may include an N-type semiconductor material. However, the present disclosure is not limited thereto, and the channel structures CH each positioned on two different base insulating patterns 103 may all include the same type of semiconductor material.

The gate structure GS may be positioned on the base insulating pattern 103. The gate structure GS may extend on the base insulating pattern 103 in a direction that is different from a direction in which the base insulating pattern 103 and the partition wall 161 extend. For example, the gate structure GS may extend on the base insulating pattern 103 in a direction (e.g., the second direction D2) that intersects the direction in which the base insulating pattern 103 and the partition wall 161 extend. The gate structures GS may be arranged spaced apart from each other in the first direction D1. The gate structure GS may include a sub-gate structure S_GS and a main gate structure M_GS. The sub-gate structure S_GS may be positioned on the base insulating pattern 103, and the main gate structure M_GS may be positioned on the sub-gate structure S_GS.

Each of the sub-gate structures S_GS may be formed of multiple layers. For example, each of the sub-gate structures S_GS may include a sub-gate electrode 120S and a sub-gate insulating layer 130S. The sub-gate structures S_GS and the channel patterns 110a, 110b, 110c, and 110d may be alternately stacked in the third direction D3. In FIG. 2, four sub-gate structure bodies S_GS are depicted as arranged and spaced apart in the third direction D3, but a number of sub-gate structure bodies S_GS arranged and spaced apart is not limited thereto. For example, the gate structure GS may include three sub-gate structures S_GS.

A plurality of sub-gate electrodes 120S may be positioned spaced apart from each other on the base insulating pattern 103. The sub-gate electrodes 120S and the channel patterns 110a, 110b, 110c, and 110d may be alternately and repeatedly stacked, for example, with one of the channel patterns positioned above and below two sub-gate electrodes 120S, and with one of the sub-gate electrodes 120S positioned above and below two channel patterns. At least one of the upper and lower surfaces of the channel patterns 110a, 110b, 110c, and 110d may be covered by the sub-gate electrodes 120S. For example, the lower surface of the first channel pattern 110a may be covered by the sub-gate electrode 120S, and the upper surface of the fourth channel pattern 110d may be covered by the sub-gate electrode 120S. The upper and lower surfaces of each of the second channel pattern 110b and the third channel pattern 110c may be covered by the sub-gate electrodes 120S.

For example, the gate electrode 120S may be formed of at least one of a metal, a metal alloy, a conductive metal nitride, a metal silicide, a doped semiconductor material, a conductive metal oxide, or conductive metal oxynitride. For example, the sub-gate electrode 120S may be formed of at least one of a titanium nitride (TiN), a tantalum carbide (TaC), a tantalum nitride (TaN), a titanium silicon nitride (TiSiN), a tantalum silicon nitride (TaSiN), a tantalum titanium nitride (TaTiN), a titanium aluminum nitride. (TiAIN), a tantalum aluminum nitride (TaAlIN), a tungsten nitride (WN), ruthenium (Ru), titanium aluminum (TiAl), a titanium aluminum carbonizationnitride (TiAIC-N), a titanium aluminum carbide (TiAlC), a titanium carbide (TiC), a tantalum carbonizationnitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), a molybdenum nitride (MoN), molybdenum carbide (MoC), a tungsten carbide (WC), rhodium (Rh), palladium (Pd), iridium (Ir), osmium (Os), silver (Ag), gold (Au), zinc (Zn), vanadium (V), or a combination thereof, but the present disclosure is not limited thereto. The conductive metal oxides and the conductive metal nitrides may include oxidized forms of the materials described above, but the present disclosure is not limited thereto.

The sub-gate insulating layer 130S may be positioned along a perimeter of the channel patterns 110a, 110b, 110c, and 110d. The sub-gate insulating layer 130S may be provided between the channel patterns 110a, 110b, 110c, and 110d and the sub-gate electrode 120S. For example, with reference to FIG. 2, a portion of the sub-gate insulating layer 130S may be positioned above one of the channel patterns and below one of the sub-gate electrodes 120S, and another portion of the sub-gate insulating layer 130S may be positioned above one of the sub-gate electrodes 120S and below one of the channel patterns. The sub-gate insulating layer 130S may be formed of various insulating materials.

In an embodiment, the sub-gate insulating layer 130S is depicted as a single film, but the present disclosure is not limited thereto. For example, the sub-gate insulating layer 130S may also be formed of a multilayer film including a silicon oxide (SiO₂) and a high dielectric constant material. In this case, the high dielectric constant material may include substances with a dielectric constant higher than that of a silicon dioxide (SiO₂), such as a hafnium oxide (HfO), an aluminum oxide (AIO), or a tantalum oxide (TaO).

The main gate structure M_GS may be positioned on the sub-gate structure S_GS and the channel patterns 110a, 110b, 110c, and 110d. The main gate structure M_GS may be positioned on the upper surface of the channel pattern 110a positioned at the uppermost position among the channel patterns 110a, 110b, 110c, and 110d. Referring to FIGS. 3 and 5, the main gate structure M_GS may also be positioned on the device isolating layer 112. The main gate structure M_GS may cover opposite side surfaces of the sub-gate structure S_GS.

The main gate structure M_GS may include a main gate electrode 120M and a main gate insulating layer 130M.

The main gate electrode 120M may be positioned on the sub-gate structure S_GS and the channel patterns 110a, 110b, 110c, and 110d. The main gate electrode 120M may be extended in a direction intersecting the base insulating pattern 103. At least a portion of the main gate electrode 120M may be positioned on the sub-gate electrode 120S and the channel patterns 110a, 110b, 110c, and 110d that are alternately stacked. A remaining portion of the main gate electrode 120M may cover a side surface of the sub-gate electrode 120S and the channel patterns 110a, 110b, 110c, and 110d that are alternately stacked. Four surfaces of the channel patterns 110a, 110b, 110c, and 110d may be surrounded by the sub-gate electrode 120S and/or the main gate electrode 120M.

The main gate electrode 120M may be formed of the same material as that of the sub-gate electrode 120S. For example, the main gate electrode 120M may be formed of at least one of a metal, a metal alloy, a conductive metal nitride, a metal silicide, a doped semiconductor material, a conductive metal oxide, or a conductive metal oxynitride.

The main gate insulating layer 130M may extend along a side surface of the main gate electrode 120M. The main gate insulating layer 130M may extend along a side surface of a gate spacer 142 described later. The main gate insulating layer 130M may be formed of various insulating materials. The main gate insulating layer 130M may be formed of the same material as that of the sub-gate insulating layer 130S.

In an embodiment, the main gate insulating layer 130M is depicted as a single film, but the present disclosure is not limited thereto. For example, the main gate insulating layer 130M may also be formed of a multilayer film including a silicon oxide (SiO₂) and a high dielectric constant material. In this case, the high dielectric constant material may include substances with a dielectric constant higher than that of a silicon dioxide (SiO₂), such as a hafnium oxide (HfO), an aluminum oxide (AIO), or a tantalum oxide (TaO).

In an embodiment, the gate structures GS respectively positioned on two different base insulating patterns 103 spaced apart from each other in the second direction D2 may be formed of different materials. For example, in FIG. 5, when different types of transistor structures are respectively positioned on the base insulating pattern 103 positioned on the left and the base insulating pattern 103 positioned on the right, materials included in the gate electrodes included in each transistor structure may be different from each other. For example, in FIG. 5, when a P-type transistor structure is positioned on the base insulating pattern 103 positioned on the left, the gate electrodes 120M and 130M included in a first gate electrode structure GS1 may be formed of a titanium nitride (TiN), but the present disclosure not limited thereto. For example, in FIG. 5, when an N-type transistor structure is positioned on the base insulating pattern 103 positioned on the right, the gate electrodes 120M and 130M be formed of in a second gate electrode structure GS2 may include a titanium aluminum carbide (TiAIC), but the present disclosure not limited thereto.

In an embodiment, some portions of the gate structure GS may be in contact with a side surface of the partition wall 161. Referring to FIG. 5, first side surfaces of a plurality of sub-gate structures S_GS positioned spaced apart in the third direction D3 may be in contact with a side surface (e.g., a first side surface) of the partition wall 161. In an embodiment, a side surface of the main gate structure M_GS may be in contact with an opposing side surface (e.g., a second side surface that is opposite the first side surface) of the partition wall 161.

The semiconductor device according to an embodiment may further include a capping layer 142 and a gate spacer 141.

The gate spacer 141 may be positioned on a side surface of the main gate electrode 120M. The gate spacer 141 may be positioned on the channel structure CH. The gate spacer 141 may not be positioned on the side surface of the sub-gate electrode 120S. The gate spacer 141 may not be positioned on a side surface of each of the channel patterns 110a, 110b, 110c, and 110d. The gate spacer 141 may not be positioned between the base insulating pattern 103 and the channel patterns 110a, 110b, 110c, and 110d. The gate spacer 141 may not be positioned between the channel patterns 110a, 110b, 110c, and 110d arranged in the third direction D3. The gate spacer 141 is illustrated as a single film, but this is merely for better understanding and ease of description, and the present disclosure is not limited thereto.

For example, the gate spacer 141 may be formed of at least one of a silicon nitride (SiNx), a silicon oxynitride (SiON), a silicon oxide (SiO₂), a silicon carbonate nitride (SiOCN), a silicon boron nitride (SiBN), a silicon oxyboron nitride (SiOBN), a silicon oxycarbide (SiOC), or a combination thereof. The gate spacer 141 is illustrated as a single film, but this is merely for better understanding and ease of description, and the present disclosure is not limited thereto.

The capping layer 142 may be positioned on, and may overlap, the main gate structure M_GS and the gate spacer 141. In an embodiment, the capping layer 142 may be extended in the first direction D1. The capping layer 142 may also be positioned on the interlayer insulating layer 171, which will be described later.

The capping layer 142 may be formed of at least one of a silicon nitride (SiN), a silicon nitride (SiON), a silicon (Si) carbonizationnitride (SiCN), a silicon carbonatenitride (SiOCN), or a combination thereof. The capping layer 142 may be formed of a material having etch selectivity with respect to a first interlayer insulating layer 171 described below.

The source/drain patterns 150 may be positioned on the upper surface of the base insulating pattern 103. The channel structure CH and the gate structure GS may be positioned between the source/drain patterns 150 in the first direction D1. The source/drain patterns 150 and the channel structures CH may be arranged alternately along the first direction D1.

The source/drain patterns 150 may also be arranged in the second direction D2. Referring to FIG. 1 and FIGS. 4 to 6, the base insulating patterns 103 may be arranged spaced apart from each other along the second direction D2, and the source/drain patterns 150 may be positioned on each of the base insulating patterns 103, such that source/drain patterns 150 may also be spaced apart from one another in the second direction D2 (e.g., with the partition wall 161 in between as illustrated in FIG. 4).

In an embodiment, two source/drain patterns 150 positioned on one base insulating pattern 103 may be positioned spaced apart from each other in the second direction D2 with the partition wall 161 therebetween. For example, referring to FIGS. 4 and 6, a first source/drain pattern 151 and the second source/drain pattern 152 positioned on the base insulating pattern 103 may be positioned spaced apart from each other in the second direction D2 with the partition wall 161 provided therebetween. In the embodiment, the first source/drain pattern 151 and the second source/drain pattern 152 may be separated from each other by the partition wall 161.

In an embodiment, the source/drain patterns 150 may include different types of semiconductor materials. For example, referring to FIG. 4, among the first source/drain patterns 151 and the second source/drain patterns 152 positioned on opposite side surfaces of the partition wall 161, a first one may include a P-type semiconductor material and a second one may include an N-type semiconductor material. Specifically, the first source/drain patterns 151 may include the P-type semiconductor material, and the second source/drain patterns 152 may include the N-type semiconductor material. However, the present disclosure is not limited thereto, and both the first source/drain patterns 151 and the second source/drain patterns 152 may include the N-type semiconductor material, or both may include the P-type semiconductor material.

Referring to FIGS. 4 and 6, at least a portion of a first side surface of the source/drain pattern 150 may be in contact with the partition wall 161. The source/drain pattern 150 may be in contact with the lower region 161a of the partition wall 161 and the side thereof, and may not be in contact with the upper region 161b of the partition wall 161. For example, the first source/drain pattern 151 may be in contact with a first side of the lower region 161a of the partition wall 161, and the second source/drain pattern 152 may be in contact with an opposing second side of the lower region 161a of the partition wall 161. In an embodiment, an etch stop film 185, which will be described later, may be positioned between the upper region 161b of the partition wall 161 and the source/drain pattern 150, for example, with the etch stop film 185 positioned between the upper region 161b and the second source/drain pattern 152.

The source/drain pattern 150 may be positioned at opposite sides of the channel structure CH or the sub-gate structure S_GS. Specifically, two source/drain patterns 150 positioned on one base insulating pattern 103 may be arranged spaced apart in a direction (e.g., the first direction D1) intersecting a direction in which the gate structure GS extends, with the channel structure CH and/or the sub-gate structure S_GS therebetween. The source/drain pattern 150 may be in contact with the channel structure CH or the sub-gate structure S_GS. The source/drain pattern 150 may contact the sub-gate insulating layer 130S of the sub-gate structure S_GS. As illustrated in FIG. 2, among the sub-gate electrodes 120S positioned spaced apart in the third direction D3, side and lower surfaces of the source/drain pattern 150 positioned at a lower level than that of the lowermost surface of the lowermost sub-gate electrode 120S may contact the base insulating pattern 103.

Referring to FIGS. 4 and 6, widths of the source/drain patterns 150 along the second direction D2 are depicted as being the same, but the present disclosure is not limited thereto. For example, the source/drain patterns 150 may have different widths along the second direction D2.

The semiconductor device according to an embodiment may further include an inner gate spacer 145 positioned between the source/drain pattern 150 and the sub-gate insulating layer 130S. The inner gate spacer 145 may be formed of at least one of a silicon nitride (SiNₓ), a silicon nitride (SiON), a silicon oxide (SiO₂), a silicon carbonate nitride (SiOCN), a silicon boron nitride (SiBN), a silicon oxyboron nitride (SiOBN), a silicon oxycarbide (SiOC), or a combination thereof. However, the present disclosure is not limited thereto, and the semiconductor device according to an embodiment may not include the inner gate spacer 145.

The source/drain pattern 150 may be formed of an epitaxial layer formed by selective epitaxial growth (SEG). The source/drain patterns 150 may be formed by removing at least a portion of a semiconductor layer positioned on the substrate 101 (see FIG. 14) and then using a selective epitaxial growth method in a corresponding region.

The source/drain pattern 150 may include a semiconductor material. The source/drain pattern 150 may be formed of silicon (Si) or germanium (Ge). In addition, the source/drain pattern 150 may be formed of a binary compound or a ternary compound including at least two or more of, e.g., carbon (C), silicon (Si), germanium (Ge), and tin (Sn). For example, the source/drain pattern 150 may include silicon (Si), silicon-germanium (SiGe), germanium (Ge), silicon carbide (SiC), and the like, but the present disclosure is not limited thereto.

The semiconductor device according to an embodiment may further include a dummy semiconductor pattern 143 positioned under the source/drain pattern 150. The dummy semiconductor pattern 143 may be configured to connect the source/drain pattern 150 to lower contact electrodes 197a and 197b, which will be described later. Unlike what is illustrated in FIG. 2 to FIG. 6, the semiconductor device according to an embodiment may not include the dummy semiconductor pattern 143. For example, the dummy semiconductor pattern 143 may be formed under the source/drain patterns 150 to be connected to the lower contact electrodes 197a and 197b. However, in other embodiments, the semiconductor device may not include the illustrated dummy semiconductor pattern 143, such that dummy semiconductor pattern 143 may not be formed under the source/drain patterns 150, and the source/drain patterns 150 may not be connected to the lower contact electrodes 197a and 197b via the dummy semiconductor pattern 143.

Referring to FIG. 2, the dummy semiconductor pattern 143 may extend into the base insulating pattern 103 in a direction toward the lower surface of the base insulating pattern 103. A lower surface of the dummy semiconductor pattern 143 may be positioned, relative to the third direction D3, between a level of the upper surface of the base insulating pattern 103 and a level of the lower surface of the base insulating pattern 103. An upper surface of the dummy semiconductor pattern 143 may be in contact with the lower surface of the source/drain pattern 150. Referring to FIG. 2, side and lower surfaces of the dummy semiconductor pattern 143 may be covered by the base insulating pattern 103.

The dummy semiconductor patterns 143 may include a semiconductor material. In an embodiment, the dummy semiconductor pattern 143 may be formed of the same material as that of the source/drain pattern 150. For example, the dummy semiconductor pattern 143 may be formed of silicon germanium (SiGe). In this case, a germanium (Ge) concentration of the dummy semiconductor pattern 143 may be different from a germanium (Ge) concentration of the source/drain pattern 150. For example, the germanium (Ge) concentration of dummy semiconductor pattern 143 may be higher than the germanium (Ge) concentration of source/drain pattern 150.

The semiconductor device according to an embodiment may further include an etch stop layer 185. The etch stop layer 185 may cover at least a portion of the upper and side surfaces of the source/drain pattern 150. The etch stop layer 185 may be positioned on at least a portion of the upper and side surfaces of the source/drain pattern 150. The etch stop layer 185 may also be positioned on an upper surface of the device isolation layer 112.

In an embodiment, the etch stop layer 185 may also be positioned between the source/drain pattern 150 and the partition wall 161. For example, the etch stop layer 185 may be positioned between the upper region 161b of the partition wall 161 and the source/drain pattern 150 (e.g., the second source drain pattern 152). The etch stop layer 185 may not be positioned between the lower region 161a of the partition wall 161 and the source/drain pattern 150. The etch stop layer 185 may include a portion that comes into contact with the upper region 161b of the partition wall 161.

The etch stop layer 185 may be formed of an insulating material. For example, the etch stop layer 185 may be formed of at least one of a silicon nitride (SiN), a silicon nitride (SiON), a silicon oxide (SiO₂), a silicon carbonate nitride (SiOCN), a silicon boron nitride (SiBN), a silicon oxyboron nitride (SiOBN), a silicon oxycarbide (SiOC), or a combination thereof. The etch stop layer 185 is illustrated as a single film, but this is merely for better understanding and ease of description, and the present disclosure is not limited thereto.

Unlike what is illustrated in FIGS. 1 to 6, the etch stop layer 185 may be omitted. In this case, the upper and side surfaces of the source/drain pattern 150 may be covered by an interlayer insulating layer 171 to be described later.

The semiconductor device according to an embodiment may further include the interlayer insulating layer 171 positioned on the device isolation layer 112 and on the upper and side surfaces of the source/drain pattern 150. In an embodiment, the etch stop layer 185 may be provided between the interlayer insulating layer 171 and the device isolation layer 112.

The interlayer insulating layer 171 may be positioned on the etch stop layer 185. In an embodiment, the interlayer insulating layer 171 may be positioned adjacent to the side surface of the source/drain pattern 150, with the etch stop layer 185 between the interlayer insulating layer 171 and the source/drain pattern 150. Alternatively, when the semiconductor device does not comprise the etch stop layer 185, the interlayer insulating layer 171 may cover, and may be in contact with, the side surface of the source/drain pattern 150.

The interlayer insulating layer 171 may be formed of an insulating material. For example, the interlayer insulating layer 171 may be formed of at least one of a silicon nitride (SiN), a silicon oxynitride (SiON), a silicon oxide (SiO₂), a silicon carbonate nitride (SiOCN), a silicon boron nitride (SiBN), a silicon oxyboron nitride (SiOBN), a silicon oxycarbide (SiOC), or a combination thereof. The interlayer insulating layer 171 is illustrated as a single film, but this is merely for better understanding and ease of description, and the present disclosure is not limited thereto.

The semiconductor device according to an embodiment may further include a first upper contact electrode 191. The first upper contact electrode 191 may be positioned on the source/drain pattern 150. The first upper contact electrode 191 may be positioned between two main gate structures M_GS spaced apart from each other in the first direction D1.

Referring to FIG. 2, the semiconductor device according to an embodiment may further include an insulating liner 187 positioned between the first upper contact electrode 191 and the gate spacer 141. For example, the insulating liner 187 may be formed of at least one of a silicon oxide (SiO₂), a silicon nitride (SiNₓ), or a silicon oxynitride (SiON).

In an embodiment, a first side surface of the first upper contact electrode 191 may be in contact with the partition wall 161. Referring to FIGS. 4 and 6, the first side surface of the first upper contact electrode 191 may be in contact with the upper region 161b of the partition wall 161.

Unlike what is illustrated in FIG. 2, a width of the first upper contact electrode 191 along a horizontal direction may not be constant. For example, the first upper contact electrode 191 may have an inclined side surface where a width of a lower portion of the first upper contact electrode 191 is narrower than a width of an upper portion of the first upper contact electrode 191 according to an aspect ratio. For example, the width of the first upper contact electrode 191 in the horizontal direction may have a shape that gradually narrows in the vertical third direction D3 toward the upper surface of the source/drain pattern 150. Accordingly, while FIG. 2 illustrates the first upper contact electrode 191 as having a constant width from a lowermost surface to an uppermost surface of the first upper contact electrode 191, the first upper contact electrode 191 is not so limited, and the first upper contact electrode 191 may have an increasing width from the lowermost surface to the uppermost surface of the first upper contact electrode 191. In this case, at least a portion of the side surface of the first upper contact electrode 191 may not be in contact with the insulating liner 187. In an embodiment, an upper surface of the first upper contact electrode 191 may be positioned on the same plane as, and may co-planar with, either or both of the upper surfaces of the gate structure GS or the partition wall 161.

Referring to FIGS. 2 and 4, the first upper contact electrode 191 may be positioned within a recess of the source/drain pattern 150, and the first upper contact electrode 191 may extend to a predetermined depth. For example, the first upper contact electrode 191 may extend through a portion of the etch stop layer 185 positioned on the upper surface of the source/drain pattern 150 and extend into an interior of the source/drain pattern 150 by a predetermined depth. The semiconductor device according to an embodiment may further include a silicide layer 157a positioned between the first upper contact electrode 191 and the source/drain pattern 150.

When the semiconductor device according to an embodiment does not include the silicide layer 157a, a portion of the side and lower surfaces of the first upper contact electrode 191 may be in contact with the source/drain pattern 150.

The semiconductor device according to an embodiment may further include a second upper contact electrode 193 positioned on the gate structure GS. The second upper contact electrode 193 may extend through a portion of the capping layer 142. A lower surface of the second upper contact electrode 193 may contact the upper surface of the main gate electrode 120M.

The semiconductor device according to an embodiment may further include an upper contact via 195 positioned on the first upper contact electrode 191. The upper contact via 195 may extend through a portion of the capping layer 142. A lower surface of the upper contact via 195 may contact the upper surface of the first upper contact electrode 191. The upper contact via 195 may be connected to the source/drain pattern 150 through the first upper contact electrode 191.

The first upper contact electrode 191, the second upper contact electrode 193, and the upper contact via 195 may be formed of a conductive material. For example, the first upper contact electrode 191, the second upper contact electrode 193, and the upper contact via 195 may be formed of at least one of a metal, a metal alloy, a conductive metal nitride, a metal silicide, a doped semiconductor material, a conductive metal oxide, or a conductive metal oxynitride.

The lower contact electrode structure 197 may be connected to the source/drain patterns 150. The lower contact electrode structure 197 may be connected to the source/drain pattern 150, and may provide power or an electrical signal to the source/drain pattern 150. Referring to FIGS. 1, 2, 4 and 6, the lower contact electrode structure 197 may be connected to lower portions of the source/drain patterns 150. The semiconductor device according to an embodiment may further include a silicide layer 157b positioned along an interface between the lower contact electrode structure 197 and the source/drain pattern 150, with the silicide layer 157b in contact with a lower surface of the source/drain pattern 150 and an upper surface of the lower contact electrode structure 197.

In an embodiment, the lower contact electrode structure 197 may be connected to two source/drain patterns 150 positioned on one base insulating pattern 103. The lower contact electrode structure 197 may include a first lower contact electrode 197a connected to a lower portion of the first source/drain pattern 151 and a second lower contact electrode 197b connected to a lower portion of the second source/drain pattern 152. In an embodiment, the lower contact electrode structure 197 may be penetrated by the partition wall 161 extending in the third direction D3, with the partition wall 161 separating the lower contact electrode 197 into the first lower contact electrode 197a (e.g., positioned on one side of the partition wall 161) and the second lower contact electrode 197b (e.g., positioned on an opposing side of the partition wall 161). In an embodiment, the lower surface of the partition wall 161 may be positioned, relative to the third direction D3, between the lower surface of the lower contact electrode structure 197 and an upper surface of a power rail 220 to be described later. The first lower contact electrode 197a and the second lower contact electrode 197b may be separated from each other by the partition wall 161, with a first side surface of the partition wall 161 in contact with the first lower contact electrode 197a and an opposing second side surface of the partition wall 161 in contact with the second lower contact electrode 197b.

In an embodiment, the lower contact electrode structure 197 may be positioned inside the base insulating pattern 103. The lower surface of the lower contact electrode structure 197 may be positioned at a higher level than a level of the lower surface of the base insulating pattern 103 and the lower surface of the device isolation layer 112. The lower contact electrode structure 197 may have a side surface that contacts the base insulating pattern 103. The lower contact electrode structure 197 may have a side surface that contacts the device isolation layer 112.

The lower contact electrode structure 197 may be formed of a conductive material. For example, the lower contact electrode structure 197 may be formed of at least one of a metal, a metal alloy, a conductive metal nitride, a metal silicide, a doped semiconductor material, a conductive metal oxide, or a conductive metal oxynitride.

The semiconductor device according to an embodiment may further include the power rail 220 positioned below the base insulating pattern 103. The power rail 220 may supply power to a semiconductor device according to an embodiment. The semiconductor device according to an embodiment may include a plurality of power rails 220 extending in a direction, for example, the first direction D1 and/or the second direction D2. Each of the power rails 220 may extend in a direction intersecting a direction in which the gate structure GS extends. For example, referring to FIG. 1, the power rail 220 may be extended in the first direction D1. For example, the power rails 220 may be positioned spaced apart from each other in the second direction D2. As such, a first power rail may extend in the first direction D1, while a second power rail may be spaced apart from the first power rail in the second direction D2 (e.g., illustrated in FIG. 4), and the second power rail may extend substantially parallel to the first power rail in the first direction D1. Unlike what is illustrated in FIG. 1, the power rails 220 may also extend in a direction parallel to a direction in which the gate structure GS extends (e.g., second direction D2).

In an embodiment, each of the power rails 220 may be connected to an external power supply. For example, the power rail 220 may be connected to an external input power supply to provide a power to the semiconductor device according to an embodiment. For example, the power rail 220 may also be connected to ground. In embodiments, the power rail 220 may be electrically connected to a circuit (e.g., external power supply), such that the circuit may provide power to the power rail 220 and, thus, the semiconductor device. As such, power supplied to the power rail 220 may be distributed to the various components, circuits, etc. of the semiconductor device. The circuit or component of the semiconductor device may draw current from the power rail 220, thus allowing the circuit or component to function. In embodiments, the power rail 220 may be connected to external pins, bonding pads, etc. and may receive voltage from a power supply, such as, for example, a voltage regulator, a DC-DC converter, battery, power management integrated circuit, or the like. In embodiments, the power rail 220 may have a line width that is larger than a line width of a signal line, for example, with the power rail 220 having a line width that is between 2x to 10x the width of a signal line, and the power rail 220 may carry currents that are within a range from 1 mA to 100mA or higher.

Each of the power rails 220 may be connected to a respective lower contact electrode structure 197 to provide a power to a source/drain patterns 150. Specifically, in FIGS. 4 and 6, the two power rails 220 positioned on the left may be connected to the first lower contact electrode 197a and the second lower contact electrode 197b, respectively. For example, one power rail 220 may be connected to the first lower contact electrode 197a through one of the lower contact vias 210, while another power rail 220 may be connected to the second lower contact electrode 197b through a different lower contact via 210. In an embodiment, the power rails 220 and the lower contact electrodes 197a and 197b may be connected to each other by the lower contact via 210 as described later.

The semiconductor device according to an embodiment may further include a lower insulating layer 167 positioned below the lower surface of the base insulating pattern 103 and the lower surface of the device isolation layer 112. The lower insulating layer 167 may surround side surfaces of the power rails 220. The lower insulating layer 167 may electrically isolate a first power rail 220 from a second power rails 220. As illustrated in FIG. 4, the lower insulating layer 167 and the power rails 220 may be arranged in an alternating manner along the second direction D2.

The semiconductor device according to an embodiment may further include a lower insulating pattern 163 positioned between the lower contact electrode structure 197 and the power rails 220. The lower insulating pattern 163 may have at least some regions of an upper surface of the lower insulating pattern 163 in contact with a lower surface of the lower contact electrode structure 197. For example, a first upper surface of the lower insulating pattern 163 may be in contact with the first lower contact electrode structure 197a, while a second upper surface of the lower insulating pattern 163 may be in contact with the second lower contact electrode structure 197b. In an embodiment, a lower surface of the lower insulating pattern 163 may be positioned at substantially the same level as that of a lower surface of the base insulating pattern 103. The lower insulating pattern 163 may have at least some regions of a lower surface in contact with an upper surface of the power rail 220.

In an embodiment, the lower insulating pattern 163 may surround at least a portion of the lower region of the partition wall 161. Specifically, the lower insulating pattern 163 may surround a portion of the partition wall 161 positioned at a lower level than that of the lower surface of the lower contact electrode structure 197. The lower region of the partition wall 161 may extend into, and may be in contact with, the lower insulating pattern 163. The partition wall 161 may extend partially, but not completely, through the lower insulating pattern 163, such that a lowermost surface of the lower insulating pattern 163 is below a lowermost surface of the partition wall 161, and an uppermost surface of the lower insulating pattern 163 is above the lowermost surface of the partition wall 161.

The lower insulating pattern 163 may be formed of an insulating material. For example, the lower insulating pattern 163 may be formed of at least one of a silicon oxide (SiO₂), a silicon nitride (SiNx), or a silicon oxynitride (SiON), but the present disclosure is not limited thereto.

The semiconductor device according to an embodiment may further include a lower contact via 210 positioned between the lower contact electrode structure 197 and the power rails 220. The lower contact via 210 may connect the lower contact electrodes 197a and 197b to the power rail 220. Referring to FIGS. 1, 4, and 6, the lower contact via 210 may extend through the lower insulating pattern 163 in the third direction D3. An upper surface of the lower contact via 210 may be connected to a lower surface of one of the lower contact electrodes 197a and 197b, and a lower surface of the lower contact via 210 may be connected to the upper surface of one of the power rails 220.

In an embodiment, a width of the lower contact via 210 in the horizontal direction may be narrower than, and less than, a width of each of the lower contact electrodes 197a and 197b in the horizontal direction. However, the present disclosure is not limited thereto, and the width of the lower contact via 210 in the horizontal direction may be substantially the same as the width of each of the lower contact electrodes 197a and 197b in the horizontal direction. As illustrated in FIG. 4, the lower contact via 210 may comprise a tapered width that increases from an uppermost surface of the lower contact via 210 toward the lowermost surface of the lower contact via 210 in the third direction D3. However, the lower contact via 210 is not limited to this shape, and instead, the lower contact via 210 may comprise a constant width in the third direction D3.

The lower contact via 210 may be formed of a conductive material. For example, the lower contact via 210 may be formed of at least one of a metal, a metal alloy, a conductive metal nitride, a metal silicide, a doped semiconductor material, a conductive metal oxide, or a conductive metal oxynitride.

Referring to FIG. 6, the semiconductor device according to an embodiment may further include a connection pattern 194 connecting two different lower contact electrode structures 197 to each other. The connection pattern 194 may be commonly connected to two different source/drain patterns 150, so signals output from the two different source/drain patterns 150 may be transmitted to other nodes. Specifically, the connection pattern 194 may transmit a signal output from at least one of two different source/drain patterns 150 to another node. For example, the connection pattern 194 may transmit a signal output from at least one of two different source/drain patterns 150 to the main gate electrode 120M via a second connection wire 192b to be described later.

Referring to FIG. 1 and FIG. 6, the connection pattern 194 may connect the lower contact electrode structures 197 which are respectively connected to two source/drain patterns 150 positioned on two different base insulating patterns 103.

In an embodiment, a lower surface of the connection pattern 194 may be positioned at the same level as that of a lower surface of the lower contact electrode structure 197. An upper surface of the connection pattern 194 may be positioned at a lower level than the level of an upper surface of the lower contact electrode structure 197. However, the present disclosure is not limited thereto, and the upper surface of the connection pattern 194 may be positioned at substantially the same level as that of the upper surface of the lower contact electrode structure 197.

In an embodiment, the connection pattern 194 may be formed simultaneously with the lower contact electrode structure 197 in the same process. In the embodiment, the connection pattern 194 may be formed integrally with the lower contact electrode structure 197, for example, with the connection pattern 194 and the lower contact electrode structure 197 formed of the same material.

The connection pattern 194 may include a conductive material. In an embodiment, the connection pattern 194 may be formed of the same material as that of the lower contact electrode structure 197. For example, the connection pattern 194 may be formed of at least one of a metal, a metal alloy, a conductive metal nitride, a metal silicide, a doped semiconductor material, a conductive metal oxide, or conductive metal oxynitride.

The semiconductor device according to the embodiment may further include connection wires 192a and 192b. The connection wires 192a and 192b may transmit electrical signals between components included in the semiconductor device according to an embodiment. For example, the connection wires 192a and 192b may transmit a signal output from the source/drain pattern 150 to another source/drain pattern 150 or the main gate electrode 120M. For example, an electrical signal transmitted through the connection wires 192a and 192b may be small in magnitude compared to an input power connected to the power rail 220.

In the semiconductor device according to the embodiment, the connection wires 192a and 192b may be positioned within the base insulating pattern 103 or the device isolation layer 112. Specifically, the connection wires 192a and 192b may be positioned at a level that is higher than that of the upper surface of the power rail 220 and at a level that is lower than a level of the upper surface of the base insulating pattern 103 or the upper surface of the device isolation layer 112. In an embodiment, the connection wires 192a and 192b may not be positioned at the same level as that of the power rail 220.

In an embodiment, the connection wires 192a and 192b may be positioned inside the base insulating pattern 103 or the device isolation layer 112, so a process margin may be secured when forming the power rail 220 under the base insulating pattern 103, thereby improving reliability of the semiconductor device.

Referring to FIGS. 4 and 6, the first connection wire 192a may connect two adjacent source/drain patterns 150 to each other. Specifically, the first connection wire 192a may be positioned on one base insulating pattern 103, and may connect two source/drain patterns 150 positioned apart in the second direction D2 with the partition wall 161 provided therebetween. The first connection wire 192a may extend in the second direction D2. The first connection wire 192a may be connected to the source/drain patterns 150 through the lower contact electrodes 197a and 197b. Referring to FIGS. 4 and 6, the first connection wire 192a may connect the first lower contact electrode 197a and the second lower contact electrode 197b separated from each other by the partition wall 161.

At least a portion of the upper surface of the first connection wire 192a may be in contact with the lower surface of the lower contact electrode structure 197. For example, a first portion of the upper surface of the first connection wire 192a may be in contact with the lower surface of the first lower contact electrode structure 197a, and a second portion of the upper surface of the first connection wire 192a may be in contact with the lower surface of the second lower contact electrode structure 197b. The first portion of the upper surface and the second portion of the upper surface may be spaced apart, and separated, from each other by the partition wall 161. In an embodiment, the first connection wire 192a may surround at least a portion of the lower region of the partition wall 161. Specifically, the first connection wire 192a may surround a portion of the partition wall 161 positioned at a lower level than that of the lower surface of the lower contact electrode structure 197. The partition wall 161 may extend partially, but not completely, through the first connection wire 192a, such that the first connection wire 192a may electrically connect the first lower contact electrode structure 197a and the second lower contact electrode structure 197b. The side surface of the first connection wire 192a may be in contact with the lower insulating pattern 163.

In an embodiment, the lower surface of the partition wall 161 including a lower region surrounded by the first connection wire 192a may be positioned at a higher level than that of the lower surface of the partition wall 161 including a lower region surrounded by the lower insulating pattern 163. This may be due to a process characteristic in which a portion of the lower region of the partition wall 161 is etched together in a process of etching the lower insulating pattern 163 to form the first connection wire 192a.

In an embodiment, the first connection wire 192a may be positioned spaced apart from the power rail 220. The first connection wire 192a may be positioned spaced apart from the power rail 220 in the third direction D3. The lower insulating pattern 165, which will be described later, may be positioned between the first connection wire 192a and the power rail 220.

The second connection wire 192b may connect the source drain/pattern 150 and the gate structure GS. Specifically, the second connection wire 192b may connect the two source/drain patterns 150 positioned on different base insulating patterns 103 to the gate structure GS. In an embodiment, the second connection wire 192b may transmit a signal output from at least one of two different source/drain patterns 150 to the gate structure GS. The second connection wire 192b may transfer a signal output from at least one of two different source/drain patterns 150 to the main gate electrode 120M.

Referring to FIG. 1, FIG. 3, FIG. 4, and FIG. 6, the second connection wire 192b may extend in the first direction D1, a first end of which is connected to the connection pattern 194, and a second end of which may be connected to a gate contact electrode 198 to be described later. The second connection wire 192b may be connected to the source/drain patterns 150 through the connection pattern 194 (e.g., with the connection pattern 194 being electrically connected to the second connection wire 192b and the source/drain patterns 150, as illustrated in FIG. 6) and to the main gate electrode 120M through the gate contact electrode 198 (e.g., with the gate contact electrode 198 being electrically connected to the second connection wire 192b and the main gate electrode 120M, as illustrated in FIG. 3).

In the embodiment, the second connection wire 192b may be positioned within the device isolation layer 112. The upper surface of the second connection wire 192b may be in contact with the device isolation layer 112, the connection pattern 194, and/or the gate contact electrode 198. The side surface of the second connection wire 192b may in contact with the device isolation layer 112.

In an embodiment, the second connection wire 192b may be positioned apart from the power rail 220. The second connection wire 192b may be positioned apart from the power rail 220 in the third direction D3. The lower insulating pattern 164, which will be described later, may be positioned between the second connection wire 192b and the power rail 220. The second connection wire 192b may be separated from the power rail 220 by the lower insulating pattern 164.

The connection wires 192a and 192b may be formed of a conductive material. The connection wires 192a and 192b may be formed of at least one of a metal, a metal alloy, a conductive metal nitride, a metal silicide, a doped semiconductor material, a conductive metal oxide, or conductive metal oxynitride.

The semiconductor device according to an embodiment may include lower insulating patterns 164 and 165 positioned between connection wires 192a and 192b and the power rail 220. The lower insulating patterns 164 and 165 may be formed of an insulating material. For example, the lower insulating patterns 164 and 165 may be formed of at least one of a silicon oxide (SiO₂), a silicon nitride (SiNₓ), or a silicon oxynitride (SiON). Due to the position of the lower insulating patterns 164 and 165, the connection wires 192a and 192b may be positioned apart from the power rail 220. For example, the lower insulating pattern 164 may be positioned vertically below, and in contact with, the second connection wire 192b. The lower insulating pattern 164 may be positioned on, and vertically above, the lower insulating layer 167, such that the lower insulating pattern 164 may be between the second connection wire 192b and the lower insulating layer 167. The lower insulating pattern 165 may be positioned vertically below, and in contact with, the first connection wire 192a. The lower insulating pattern 165 may be positioned on, and vertically above, the lower insulating layer 167 and the power rail 220, such that the lower insulating pattern 165 may be between the first connection wire 192a (e.g., on an upper side of the lower insulating pattern 165) and the lower insulating layer 167 and the power rail 220 (e.g., on a lower side of the lower insulating pattern 165).

Another semiconductor device according to an embodiment may further include a gate contact electrode 198 positioned between the second connection wire 192b and the gate structure GS. The gate contact electrode 198 may transfer an electrical signal to the gate structure GS from the second connection wire 192b, as illustrated in FIG. 3. The gate contact electrode 198 may extend in the third direction D3. A first end of the gate contact electrode 198 may be connected to the second connection wire 192b and a second end of the gate contact electrode 198 may be connected to the main gate electrode 120M.

The gate contact electrode 198 may be formed of a conductive material. For example, the gate contact electrode 198 may be formed of at least one of a metal, a metal alloy, a conductive metal nitride, a metal silicide, a doped semiconductor material, a conductive metal oxide, or a conductive metal oxynitride.

Referring to FIG. 7, a semiconductor device according to an embodiment may include a node contact electrode 199. For example, in some embodiments, the gate electrode and the source electrode or the drain electrode included in one transistor structure may be directly connected. In this case, as illustrated in FIG. 7, the source/drain pattern 150 connected to the gate structure GS and the channel patterns 110a, 110b, 110c, and 110d surrounded by the gate structure GS may be connected using the node contact electrode 199.

In an embodiment, the node contact electrode 199 may be positioned within the base insulating pattern 103. The node contact electrode 199 may have an upper surface in contact with the gate structure GS, and the node contact electrode 199 may have a first side surface in contact with the lower contact electrode structure 197. Referring to FIG. 7, a width of the node contact electrode 199 in the first direction D1 may gradually decrease as it approaches a lower surface of the gate structure GS. For example, the width of the node contact electrode 199 may decrease in the third direction D3 away from the power rail 220. Referring to FIG. 7, the node contact electrode 199 may have an inclined side surface having a width in the first direction D1 that becomes narrower from a lower surface to an upper surface.

The node contact electrode 199 may be formed of at least one of a metal, a metal alloy, a conductive metal nitride, a metal silicide, a doped semiconductor material, a conductive metal oxide, or a conductive metal oxynitride.

The lower insulating pattern 163 may be positioned between the node contact electrode 199 and the power rail 220, for example, with the lower insulating pattern 163 in contact with a lowermost surface of the node contact electrode 199 and an uppermost surface of the power rail 220. The node contact electrode 199 may be separated from the power rail 220 by the lower insulating pattern 163.

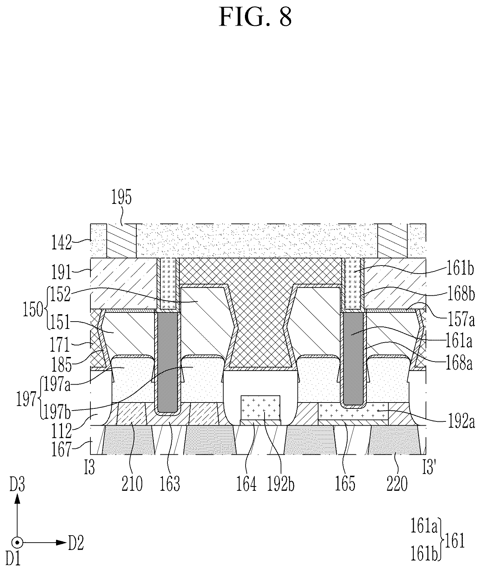

FIG. 8 illustrates a semiconductor device according to an embodiment. The semiconductor device illustrated in FIG. 8 has many similarities to the previous embodiments so the following description focuses mainly on the differences from the previous embodiments. FIG. 8 illustrates a cross-section taken along line I3-I3' of FIG. 1.

FIG. 8 illustrates the semiconductor device according to an embodiment that differs from previous embodiments in certain aspects, as the semiconductor device includes the insulating liner 168 surrounding the partition wall 161.

Referring to FIG. 8, the semiconductor device according to an embodiment may further include a first insulating liner 168a surrounding side and lower surfaces of the lower region 161a of the partition wall 161 and a second insulating liner 168b surrounding side and lower surfaces of the upper region 161b of the partition wall 161.

The first insulating liner 168a may be conformally positioned on the side and lower surfaces of the lower region 161a of the partition wall 161. In an embodiment, the first insulating liner 168a may be formed of an insulating material that is different from an insulating material of the lower region 161a of the partition wall 161. The first insulating liner 168a may be formed of at least one of a silicon oxide (SiO₂), a silicon nitride (SiNₓ), or a silicon oxynitride (SiON), but the present disclosure is not limited thereto.

The second insulating liner 168b may be conformally positioned on the side and lower surfaces of the lower region 161b of the partition wall 161. In an embodiment, the second insulating liner 168b may be formed of an insulating material that is different from an insulating material of the upper region 161b of the partition wall 161. The second insulating liner 168b may be formed of at least one of a silicon oxide (SiO₂), a silicon nitride (SiNx), or a silicon oxynitride (SiON), but the present disclosure is not limited thereto.

Unlike what is illustrated in FIG. 8, either the lower region 161a or the upper region 161b of the partition wall 161 may not include the insulating liners 168a and 168b. For example, the lower region 161a may be surrounded by the first insulating liner 168a while the upper region 161b may not be surrounded by the second insulating liner 168b, such that the upper region 161b may be in contact with surrounding structures (e.g., the upper contact electrode 191, etc.). Alternatively, the lower region 161a may not be surrounded by the first insulating liner 168a while the upper region 161b may be surrounded by the second insulating liner 168b, such that the lower region 161a may be in contact with surrounding structures (e.g., the source/drain pattern 150, the lower contact electrode structure 197, etc.).

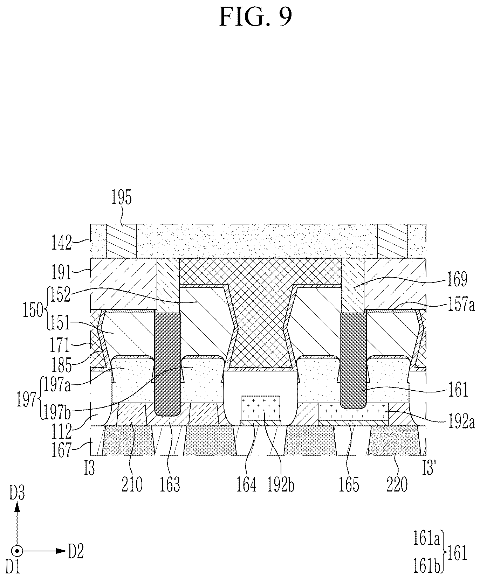

FIG. 9 illustrates a view for describing a semiconductor device according to embodiment. The semiconductor device illustrated in FIG. 9 has many similarities to the previous embodiments so the following description focuses mainly on the differences from the previous embodiments. FIG. 9 illustrates a cross-section taken along line I3-I3' of FIG. 1.

Referring to FIG. 9, the semiconductor device according to an embodiment may include a contact isolation pattern 169 positioned on the partition wall 161. The contact isolation pattern 169 may be used to electrically insulate the upper contact electrode 191 from another upper contact electrode 191. The contact isolation pattern 169 according to an embodiment may be positioned between the two source drain patterns 150 positioned at opposite sides of the partition wall 161. As illustrated in FIG. 9, the contact isolation pattern 169 may be positioned above, and overlapping, the lower region 161a of the partition wall 161 such that the contact isolation pattern 169 may be located at the same location as the upper region 161b of the partition wall 161 (e.g., in comparison to the position of the upper region 161b of the partition wall 161 in FIG. 4).

An upper surface of the contact isolation pattern 169 may be in contact with the lower surface of the capping layer 142. A lower surface of contact isolation pattern 169 may come into contact with the upper surface of the partition wall 161. The contact isolation pattern 169 may contact a portion of the side surface of the source/drain pattern 150 and a portion of the side surface of the upper contact electrode 191. In an embodiment, the etch stop layer 185 may not be positioned at an interface between the contact isolation pattern 169 and the source drain pattern 150.

Unlike what is illustrated in FIG. 9, an insulating liner may be further positioned on the side and bottom surface of the contact isolation pattern 169. For example, similar to the position of the second insulating liner 168b in FIG. 8, the second insulating liner 168b may be positioned on side and bottom surfaces of the contact isolation pattern 169 in FIG. 9.

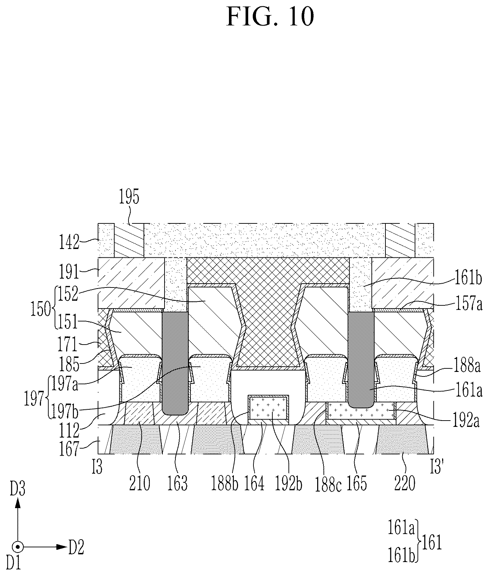

FIG. 10 illustrates a view for describing a semiconductor system according to an embodiment. The semiconductor device illustrated in FIG. 10 has many similarities to the previous embodiments so the following description focuses mainly on the differences from the previous embodiments. FIG. 10 illustrates a cross-section taken along line I3-I3' of FIG. 1.

The semiconductor device according to an embodiment may further include an insulating liner positioned on at least a portion of the side and upper surfaces of the lower contact electrodes 197a and 197b and the connection electrodes 192a and 192b.

Specifically, referring to FIG. 10, an insulating liner 188a may be positioned on the side surface of the first lower contact electrode 197a and the second lower contact electrode 197b, such that the insulating liner 188a is in contact with the lower contact electrodes 197a, 197b (e.g., on an inner first side of the insulating liner 188a), and the insulating liner 188a is in contact with adjacent structures, such as the lower region 161a, the device isolation layer 112, etc. (e.g., on an outer second side of the insulating liner 188a). An insulating liner 188b may be positioned on the side and upper surfaces of the second connection wire 192b, such that the insulating liner 188b is in contact with the second connection wire 192b (e.g., on an inner first side of the insulating liner 188b), and the insulating liner 188b is in contact with the device isolation layer 112 (e.g., on an outer second side of the insulating liner 188b). An insulating liner 188c may be positioned on the side surface of the first connection wire 192a, such that the insulating liner 188c is in contact with the first connection wire 192a (e.g., on an inner first side of the insulating liner 188c), and the insulating liner 188c is in contact with the lower insulating pattern 163 (e.g., on an outer second side of the insulating liner 188c).

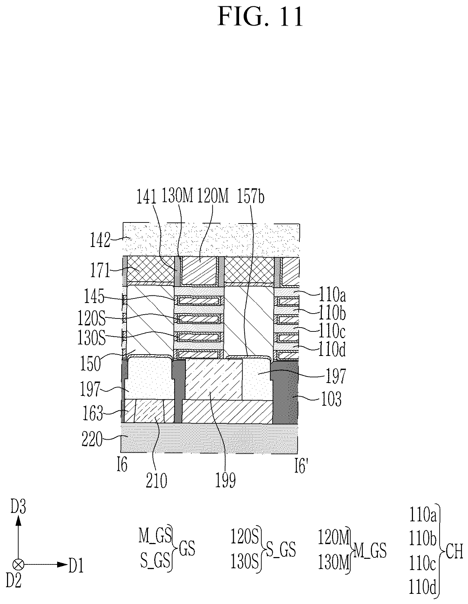

FIG. 11 illustrates a view for describing a semiconductor system according to an embodiment. The semiconductor device illustrated in FIG. 11 has many similarities to the previous embodiments so the following description focuses mainly on the differences from the previous embodiments. FIG. 11 illustrates a cross-section taken along line I6-I6' of FIG. 1. The semiconductor device according to an embodiment may have a shape of the node contact electrode 199 that is slightly different from the shape of the node contact electrode 199 of FIG. 7.

Specifically, referring to FIG. 11, in the embodiment, a width of the node contact electrode 199 along the first direction D1 may be wider compared to the width of the node contact electrode 199 along the first direction (D1) described with reference to FIG. 7. In an embodiment, the node contact electrode 199 may have a constant width as measured along the first direction D1 from the lowermost surface of the node contact electrode 199 to the uppermost surface of the node contact electrode 199 in the third direction D3.

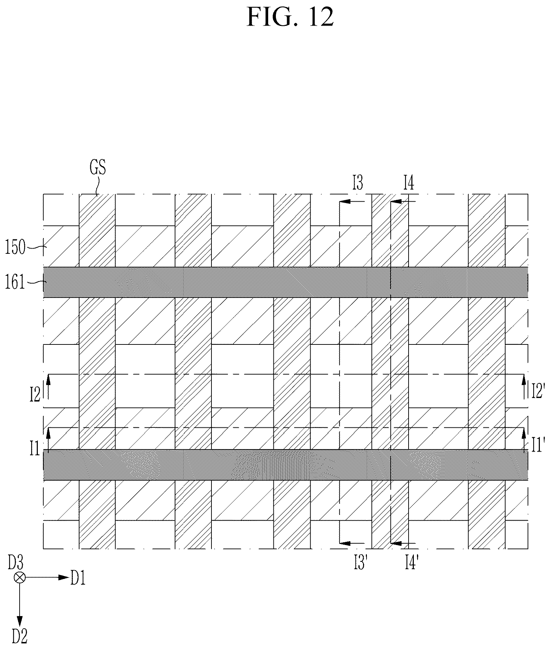

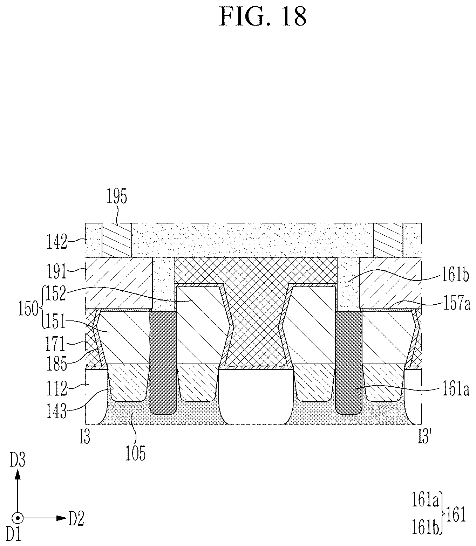

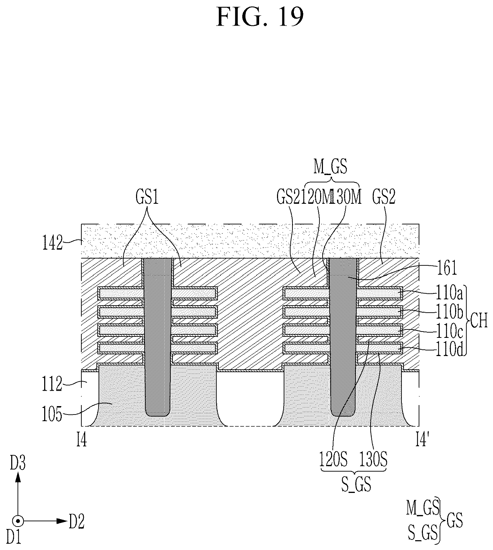

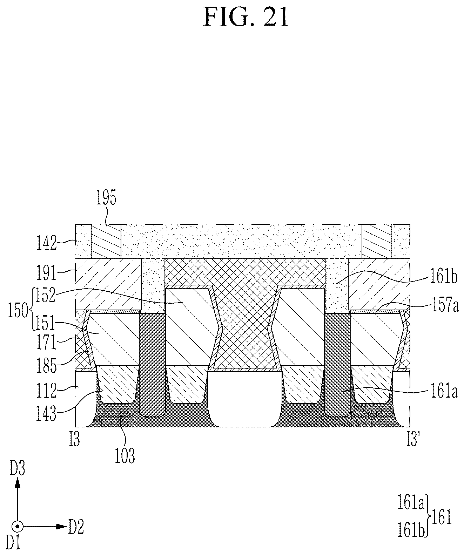

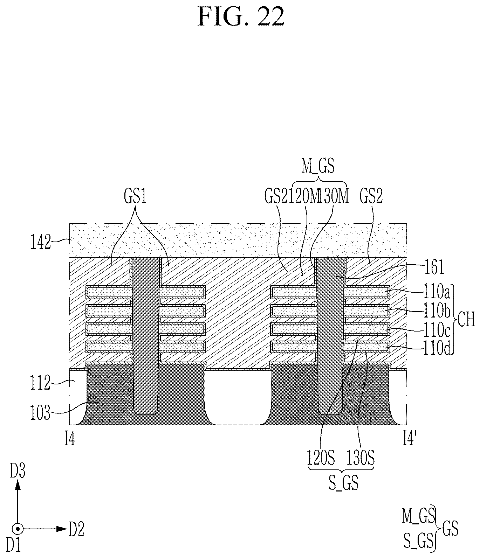

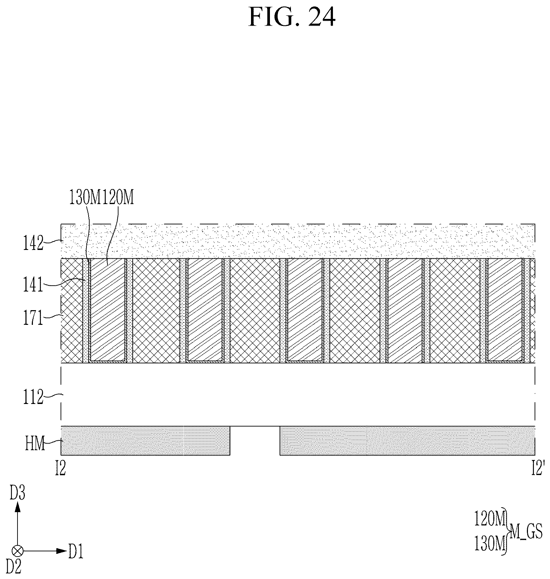

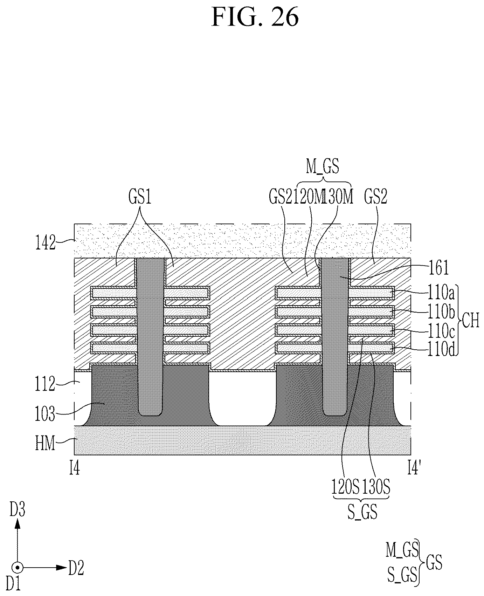

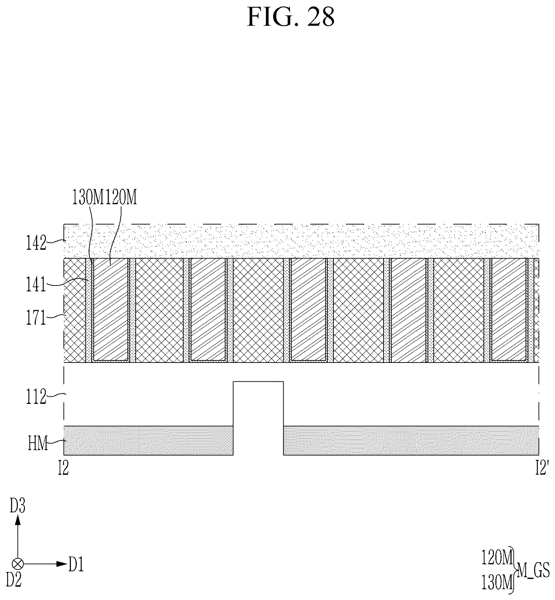

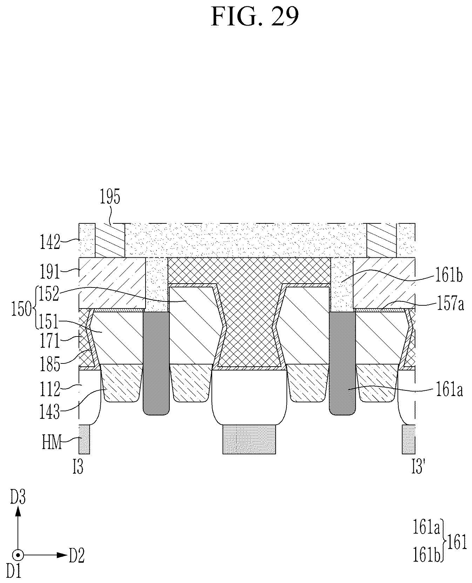

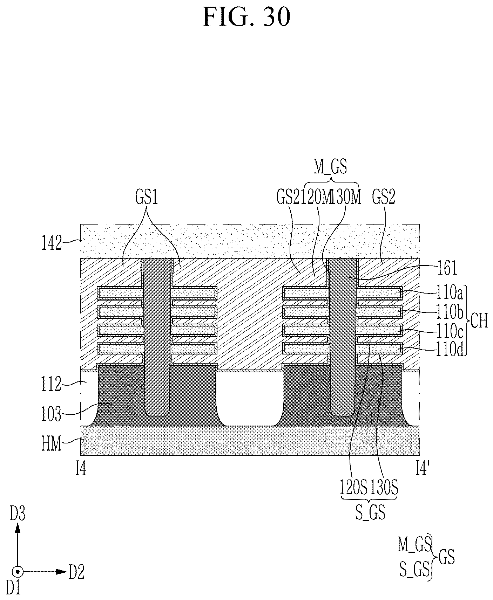

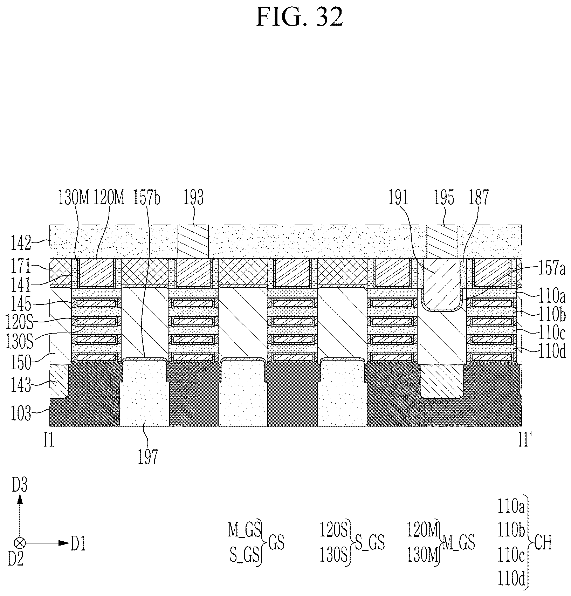

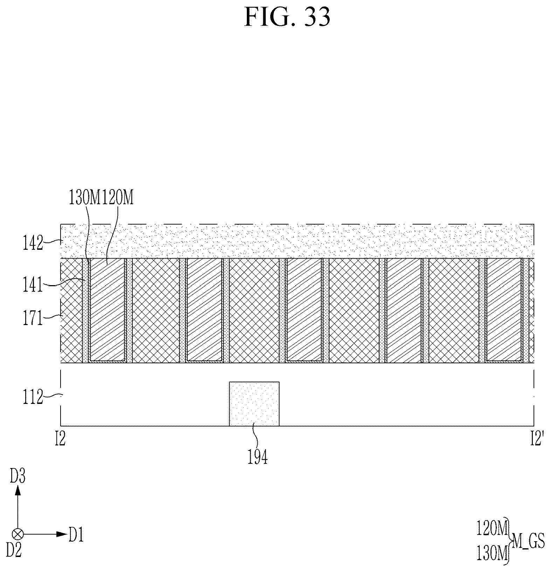

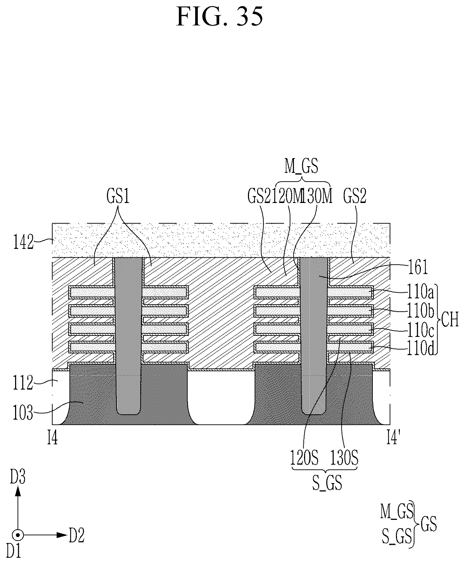

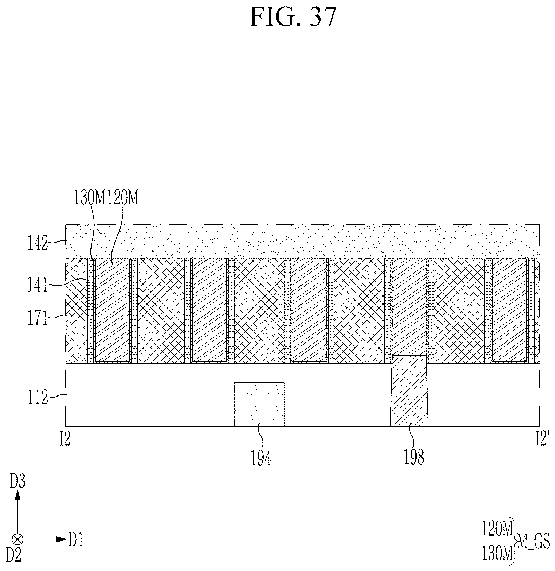

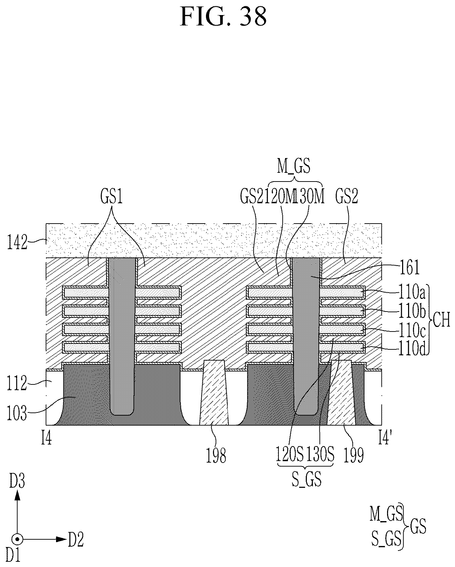

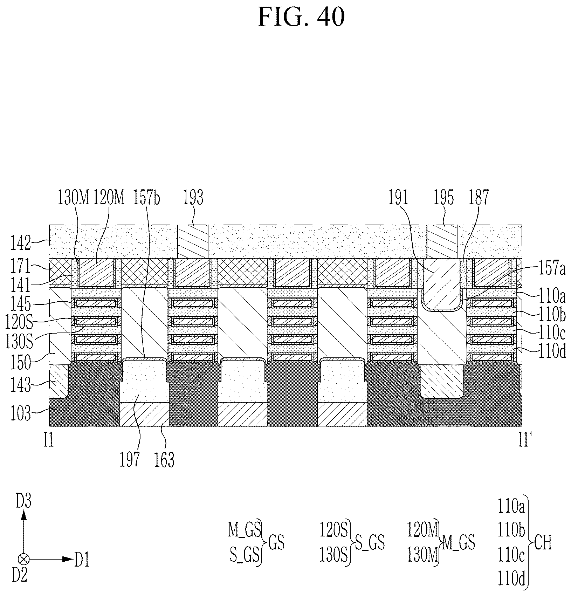

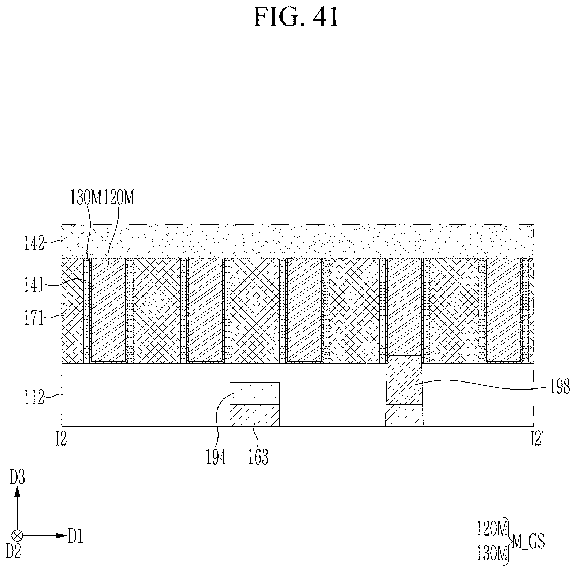

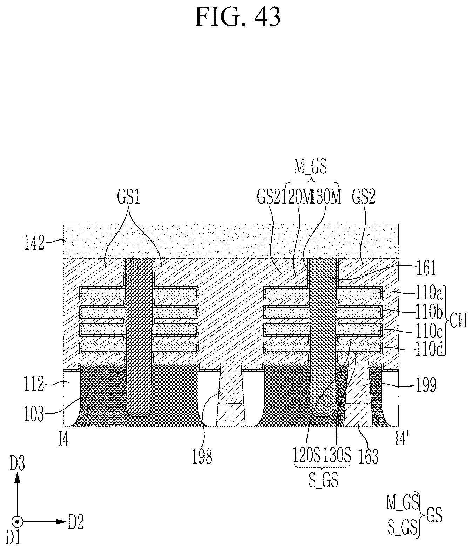

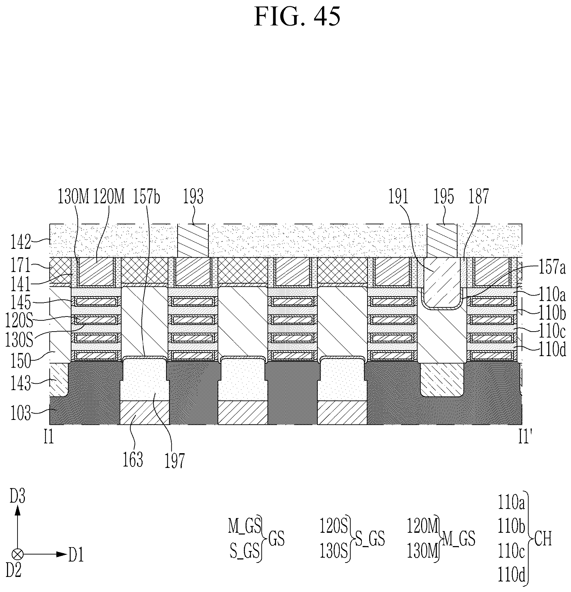

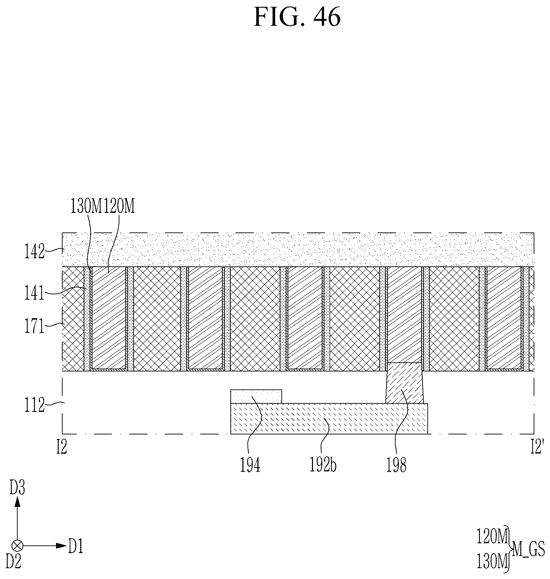

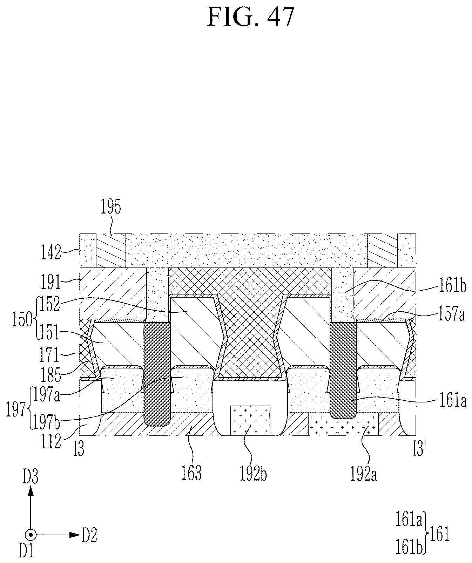

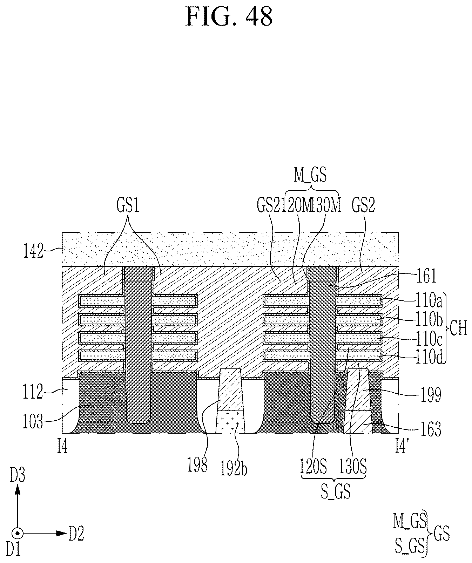

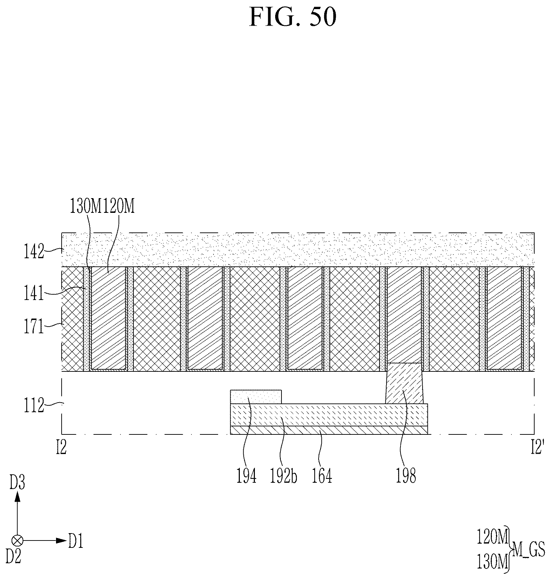

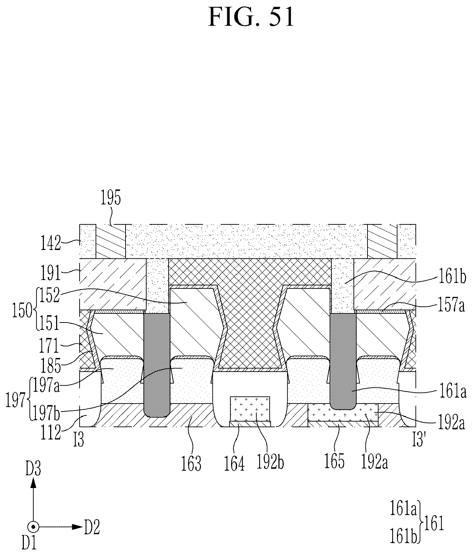

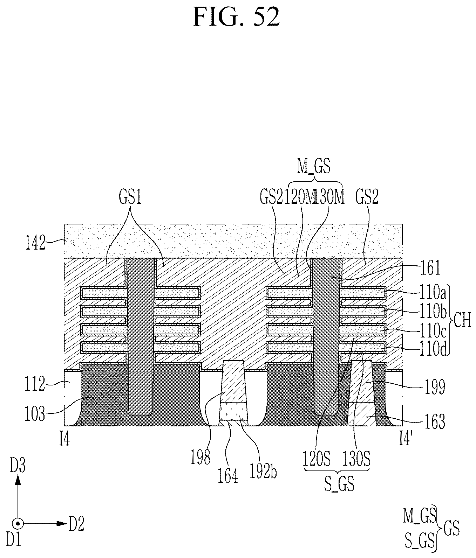

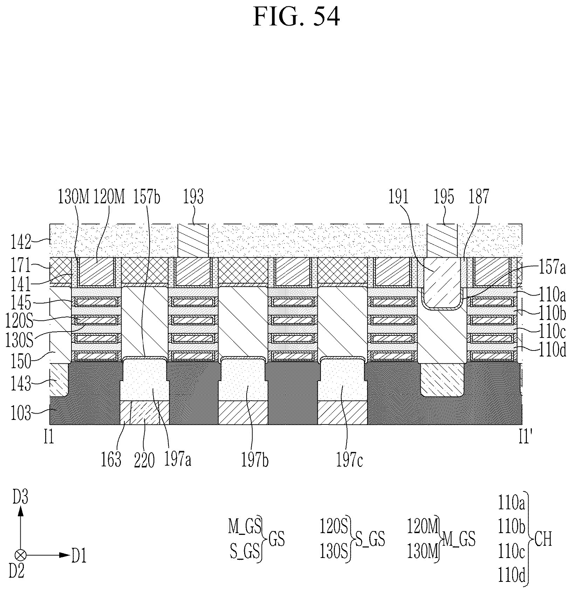

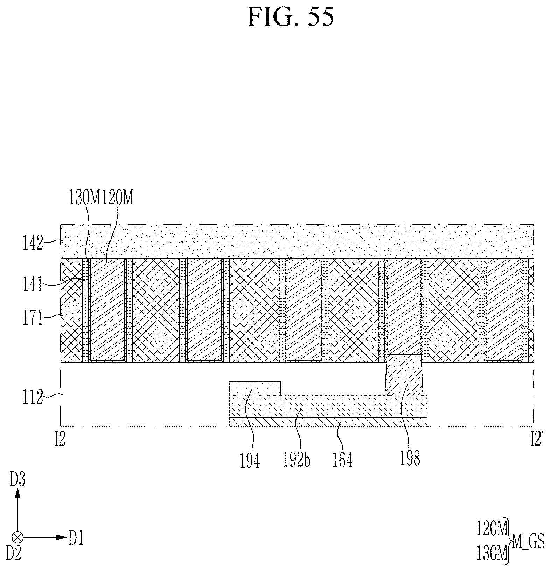

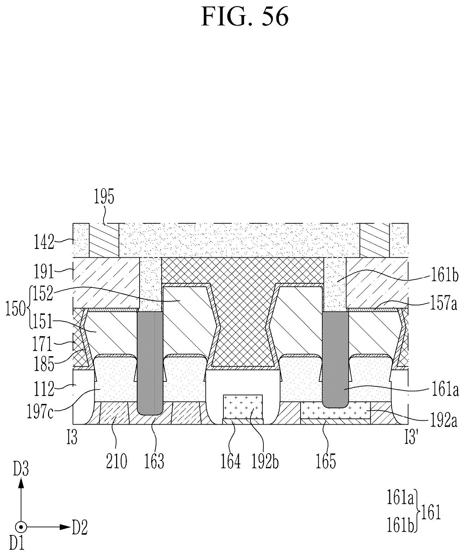

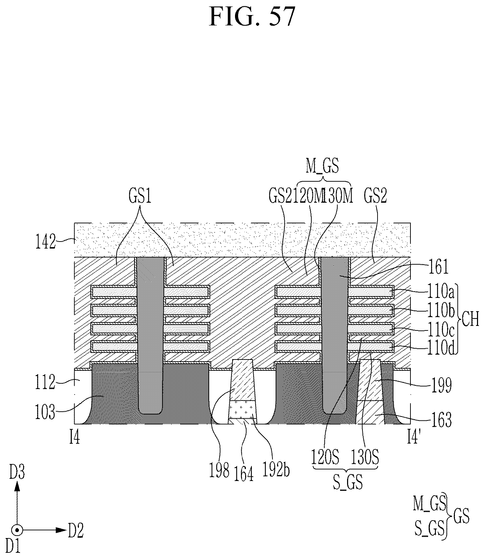

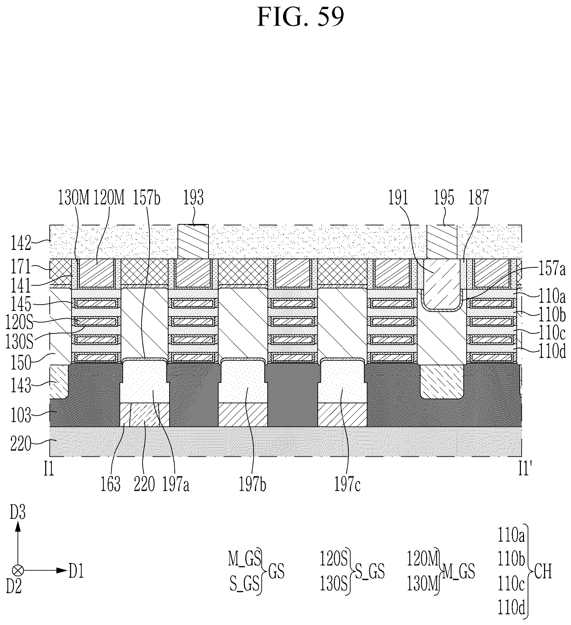

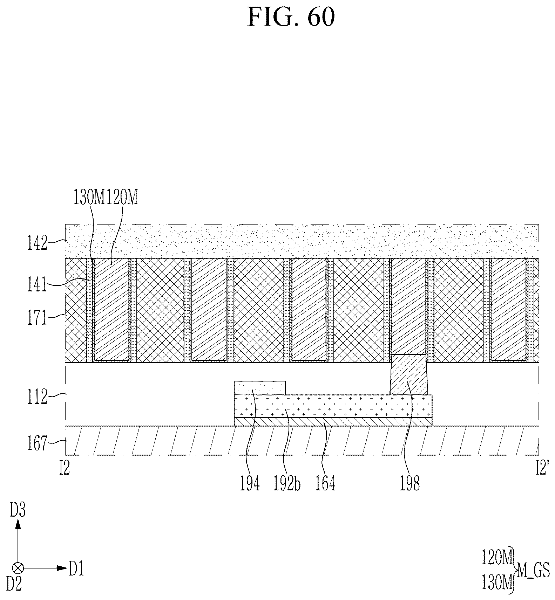

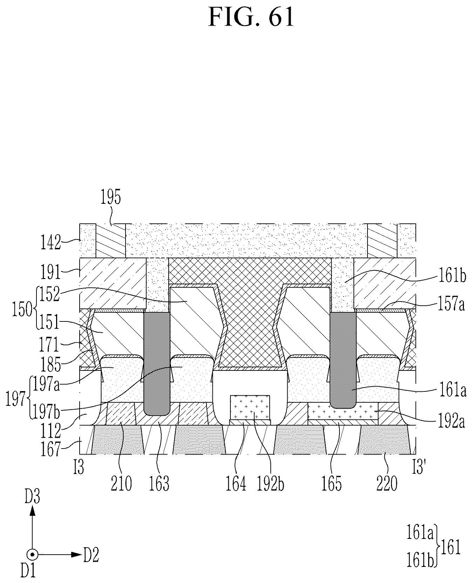

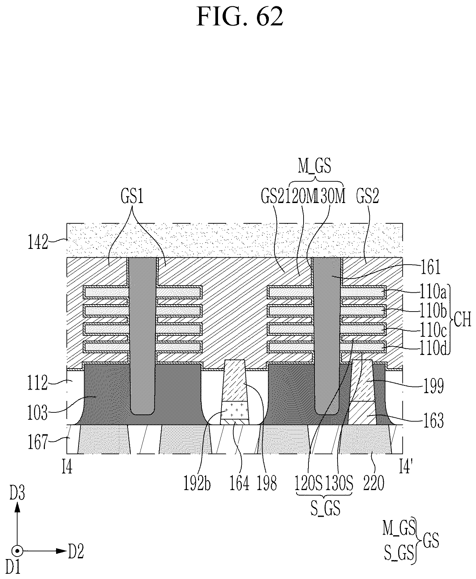

FIG. 12 to FIG. 62 illustrate process cross-sectional views for describing a manufacturing method for a semiconductor package according to an embodiment.

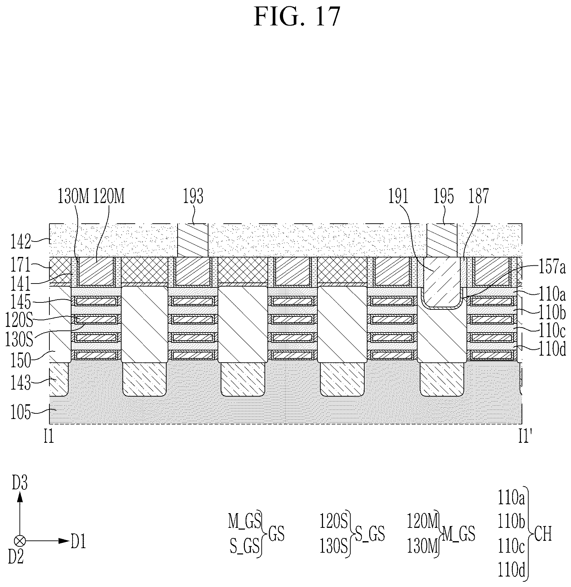

FIG. 17, FIG. 42, FIG. 46, and FIG. 56 illustrate cross-sectional views corresponding to the region taken along line I1-I1', I3-I3', I2-I2', and I3-I3', respectively, of FIG. 1, showing a manufacturing method for a semiconductor device according to an embodiment.

FIG. 12, FIG. 31, FIG. 36, FIG. 39, FIG. 44, FIG. 53, and FIG. 58 illustrate top plan views according to each operation of a manufacturing process for a semiconductor device according to an embodiment, FIG. 13, FIG. 17, FIG. 20, FIG. 23, FIG. 27, FIG. 32, FIG. 40, FIG. 45, FIG. 49, FIG. 54, and FIG. 59 illustrate cross-sectional views corresponding to the region taken along line I1-I1' of FIG. 1,

FIG. 14, FIG. 24, FIG. 28, FIG. 33, FIG. 37, FIG. 41, FIG. 46, FIG. 50, FIG. 55 and FIG. 60 illustrate cross-sectional views corresponding to the region taken along line I2-I2' of FIG. 1,

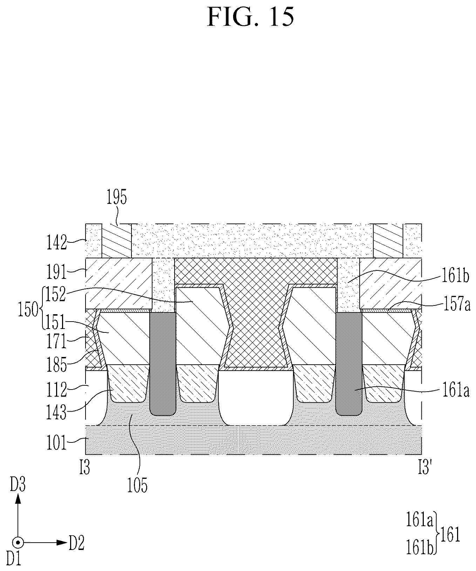

FIG. 15, FIG. 18, FIG. 21, FIG. 25, FIG. 29, FIG. 34, FIG. 42, FIG. 47, FIG. 51, FIG. 56, and FIG. 61 illustrate cross-sectional views corresponding to the region taken along line I3-I3' of FIG. 1, and

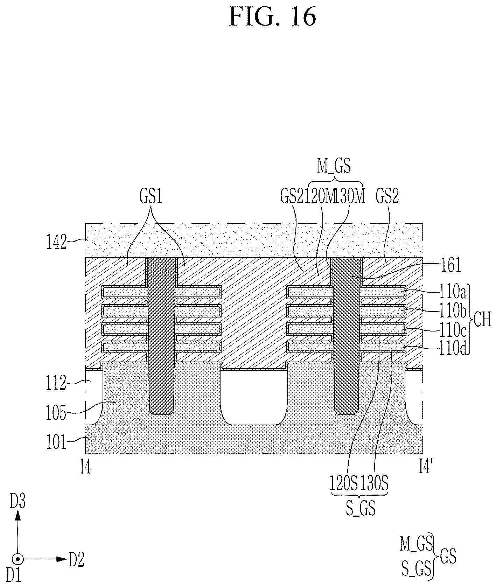

FIG. 16, FIG. 19, FIG. 22, FIG. 26, FIG. 30, FIG. 35, FIG. 38, FIG. 43, FIG. 48, FIG. 52, FIG. 57, and FIG. 62 illustrate cross-sectional views corresponding to the region taken along line I4-I4' of FIG. 1.

As illustrated in FIGS. 12 to 16, a substrate 101, lower patterns 105 on the substrate 101, partition walls 161 positioned on the lower patterns 105, device isolation layers 112 positioned at opposite sides of the lower patterns 105, channel structures CH, gate structures GS surrounding the channel structures CH, source/drain patterns 150 respectively connected to opposite sides of each of the channel structures CH, and upper contact electrodes 191 and 193 respectively connected to the gate structures GS and the source/drain patterns 150 may be formed.

First, the lower pattern 105 may be positioned on the substrate 101, and sacrificial layers and channel patterns 110a, 110b, 110c, and 110d may be alternately stacked on the lower pattern 105. The device isolation layer 112 may be positioned at opposite sides of the lower pattern 105. In an embodiment, the substrate 101 may be silicon-on-insulator (SOI) or bulk silicon. Alternatively, the substrate 101 may be a silicon substrate, or may be formed of other materials, such as silicon germanium (SiGe), silicon germanium on insulator (SGOI), indium antimonide, a lead tellurium compound, indium arsenide, indium phosphide, gallium arsenide, or gallium antimonide, but the present disclosure is not limited thereto.

Thereafter, some regions of the sacrificial layers and the channel patterns 110a, 110b, 110c, 110d may be etched, and then an insulating material may be provided to form the partition 161. In an embodiment, the partition wall 161 may extend into an interior of the lower pattern 105. Next, after etching some regions of the sacrificial layers and the channel patterns 110a, 110b, 110c, and 110d, the source and drain patterns 150 may be formed using an epitaxial growth method. In this case, in the process of etching some regions of the sacrificial layers and the channel patterns 110a, 110b, 110c, and 110d, a portion of the upper region of the partition wall 161 may be etched together. In this case, a level at which the upper surface of the partition wall 161 positioned between the two source/drain patterns 150 is positioned may be lower than a level at which the upper surface of the partition wall 161 positioned between the two channel structures CH is positioned.

In an embodiment, dummy semiconductor patterns 143 may be further formed in some regions of the lower pattern 105 under the source drain/pattern 150. Next, after removing sacrificial layers, the gate structures GS may be formed in the region where the sacrificial layers were positioned. Next, the source drain/patterns 150, the interlayer insulating layer 171 covering the gate structure GS and the capping layer 142 are formed, and the second upper contact electrode 193 and the upper contact via 195 may be formed by photo and etching processes.

As shown in FIGS. 17 to 19, a lower portion of the substrate 101 may be etched. To etch the lower portion of substrate 101, at least one of a grinding process, a chemical mechanical polishing process, or a wet etching process may be performed. In an embodiment, the substrate 101 positioned below the lower pattern 105 may be completely removed. In this case, the lower surface of the device isolation 112 may be used as an etch stop layer.

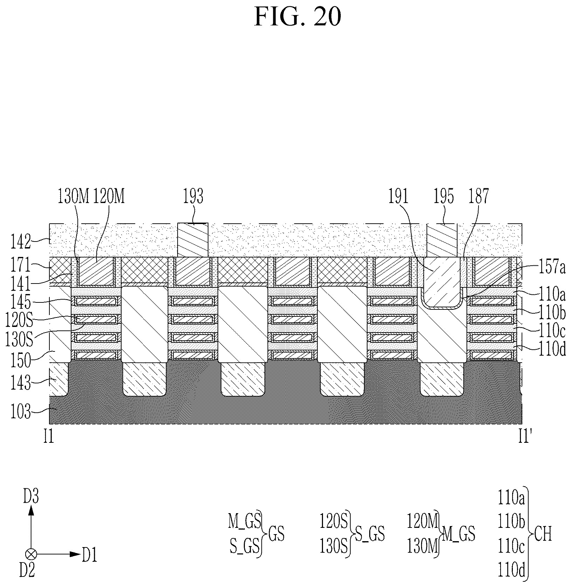

As illustrated in FIGS. 20 to 22, after removing the lower pattern 105, a region where the lower pattern 105 was positioned may be filled with an insulating material to form the base insulating pattern 103. For example, the lower pattern 105 may be etched using a wet etching process. In this case, the lower pattern 105 may be completely etched using an etchant having a higher etching selectivity compared to the device isolation layer 112, the partition wall 161, and the dummy semiconductor pattern 143. The base insulating pattern 103 may be formed by depositing an insulating material in the region where the lower pattern 105 was positioned. The insulating material may be formed of at least one of a silicon oxide (SiO₂), a silicon nitride (SiNx), or a silicon oxynitride (SiON), but the present disclosure is not limited thereto. In the embodiment, after forming the base insulating pattern 103, a chemical mechanical polishing process may be performed to planarize a lower surface of the base insulating pattern 103. In this case, the lower surfaces of the base insulating pattern 103 and the device isolation layer 112 may be positioned at substantially the same level.

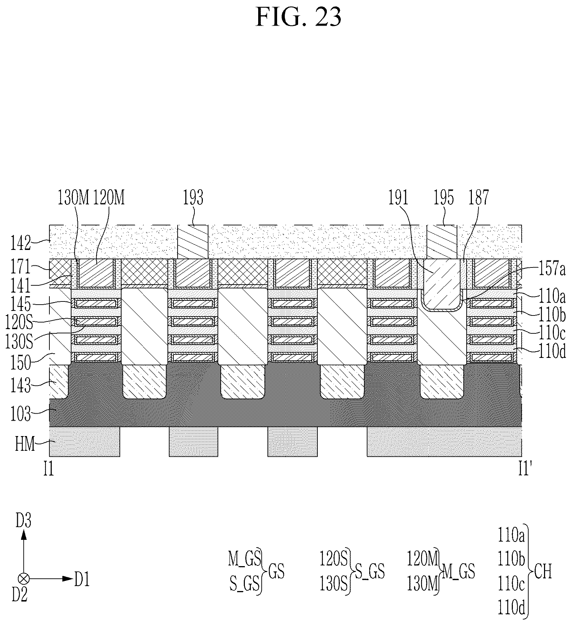

As illustrated in FIGS. 23 to 26, a hard mask pattern HM may be formed on a portion of the lower surface of the device isolation layer 112 and the base insulating pattern 103.

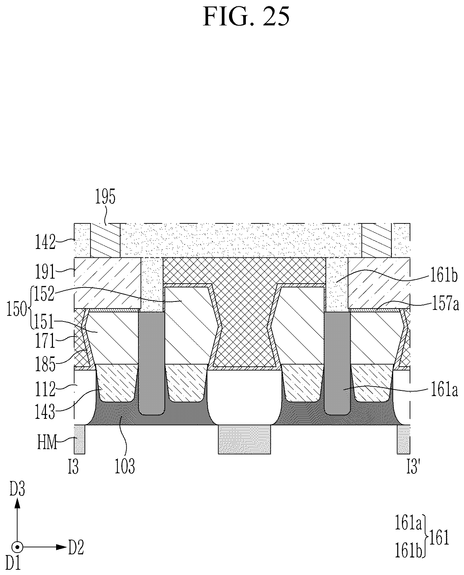

First, an insulating material may be deposited on entire regions of the lower surfaces of the device isolation layer 112 and the base insulating pattern 103, and then a portion of the insulating material may be etched to form a hard mask pattern HM. For this purpose, a photolithography process may be performed. In this case, some regions of the lower surface of the base insulating pattern 103 may be exposed through the hard mask pattern HM. Referring to FIG. 25, a portion of the base insulating pattern 103 exposed by the hard mask pattern HM may include a region overlapping the partition wall 161 and the source/drain patterns 150 positioned at opposite sides of the partition wall 161 in the third direction D3.

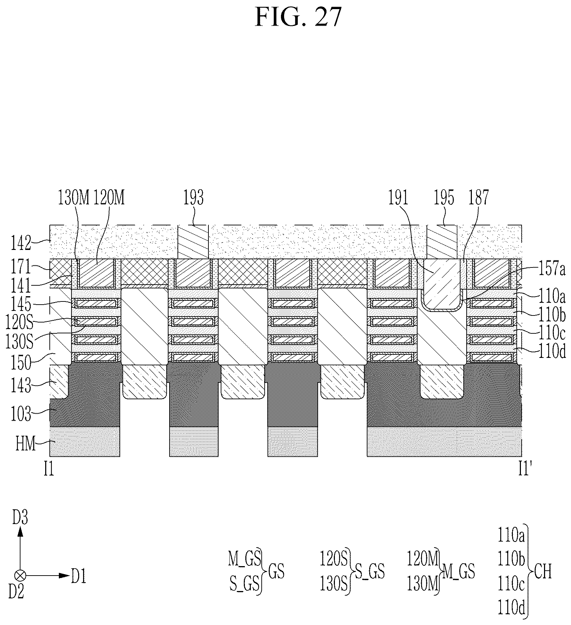

As illustrated in FIGS. 27 to 30, a portion of the base insulating pattern 103 exposed through the hard mask pattern HM may be etched. A process of etching a portion of the base insulating pattern 103 may be performed using an etchant or etching gas having a higher etching selectivity for the base insulating pattern 103 compared to the partition wall 161, the dummy semiconductor pattern 143, and the device isolation layer 112. As a portion of the base insulating pattern 103 is etched, a portion of the lower portion of the partition wall 161 and a portion of the lower portion of two dummy semiconductor patterns 143 positioned at opposite sides of the partition wall 161 may be exposed to an outside.

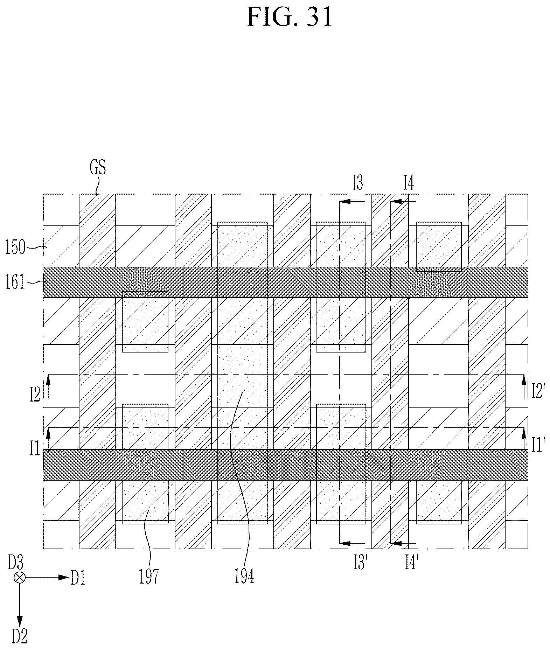

As illustrated in FIGS. 31 to 34, a conductive material may be deposited on the lower portion of the base insulating pattern 103 to form the lower contact electrode structure 197.

First, the dummy semiconductor patterns 143 exposed to the outside may be etched. Next, a conductive material may be deposited on the etched portion of the base insulating pattern 103 and the dummy semiconductor pattern 143 to form the lower contact electrode structure 197. In this case, a portion of the lower region of the partition wall 161 that was exposed to the outside by the etching process may be covered by the lower contact electrode structure 197.

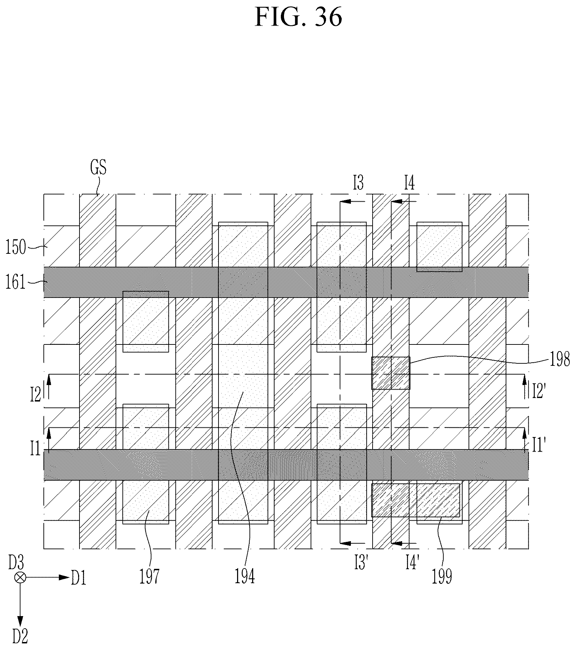

As illustrated in FIGS. 36 to 38, the gate contact electrode 198 and the node contact electrode 199 connected at a first end to the gate structure GS may be formed. First, by a photolithography process, a portion of the device isolation layer 112 overlapping the gate structure GS in the third direction D3 and a portion of the base insulating pattern 103 may be etched. Thereafter, the etched region may be filled with a conductive material to form each of the gate contact electrode 198 and the node contact electrode 199.

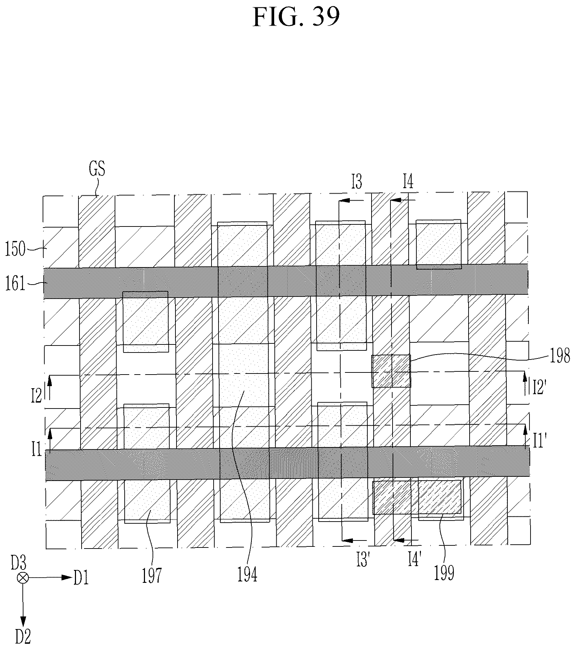

Next, as illustrated in FIGS. 39 to 43, the lower contact electrode structure 197, for example, the first lower contact electrode 197a and the second lower contact electrode 197b, and some regions of the gate contact electrode 198 and the node contact electrode 199 may be etched again, and then an insulating material may be filled in the etched portion to form the lower insulating pattern 163.

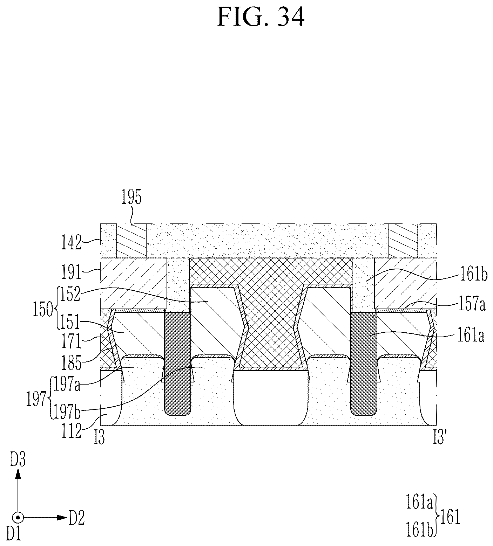

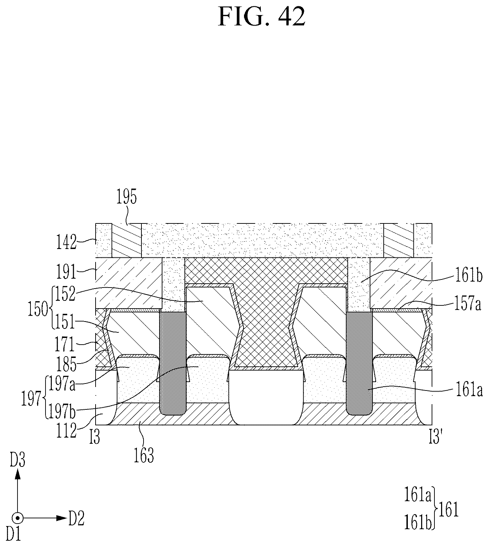

In an embodiment, a portion of the lower region of the partition wall 161 may be exposed to the outside again by an etch back process that re-etches the lower contact electrode structure 197. The lower contact electrode structure 197 may be separated into two lower contact electrodes 197a and 197b by the partition 161. In an embodiment, when forming contacts between two source/drain patterns 150 adjacent to each other in the second direction D2, a self-align contact may be formed by using the partition 161 positioned between the two source/drain patterns. For example, with reference to FIGS. 34 and 42, the lower contact electrode structure 197 may, initially, surround a lower portion of the partition 161 (e.g., illustrated in FIG. 34) such that a lowermost surface of the partition 161 is surrounded by, and in contact with, the lower contact electrode structure 197. The etch back process may result in the removal of a lower portion of the lower contact electrode structure 197 without removing, or only minimally removing, the partition 161. After the etch back process, and as illustrated in FIG. 42, a lowermost region of the lower contact electrode structure 197 has been removed, thus exposing a lower portion of the partition 161. As such, the lower contact electrode structure 197 is separated into the first and second lower contact electrodes 197a, 197b, with the partition 161 extending between, and past, the first and second lower contact electrodes 197a, 197b. Accordingly, a process margin may be increased in the patterning process for forming the lower contact electrodes 197a and 197b, and reliability of the semiconductor device according to an embodiment may be improved. The lower insulating pattern 163 may be positioned below a lower surface of the lower contact electrode structure 197. In an embodiment, the lower insulating pattern 163 may surround a portion of the lower region of the partition wall 161 positioned below the lower surface of the lower contact electrode structure 197.

In an embodiment, the lower insulating pattern 163 may also be positioned below the gate contact electrode 198 and the node contact electrode 199.

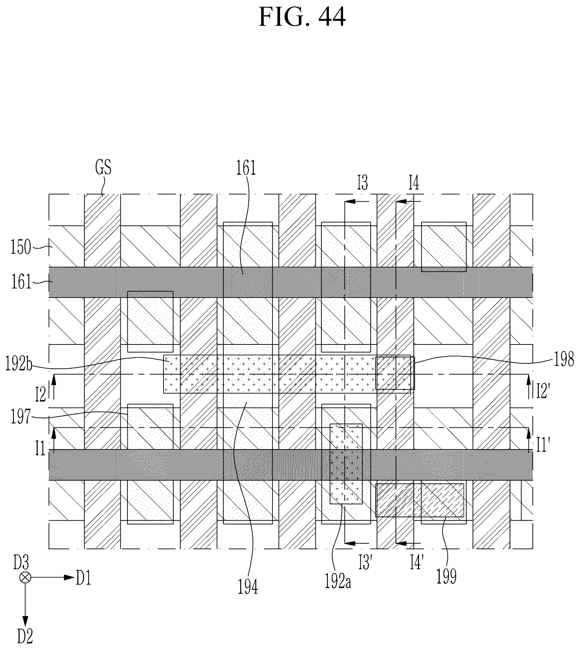

As illustrated in FIG. 44 to FIG. 48, the connection wires 192a and 192b described with reference to FIG. 1 to FIG. 7 may be formed.

The first connection wire 192a may be formed by etching a portion of the lower insulating pattern 163 that overlaps the partition wall 161 in the third direction D3, and then filling it with a conductive material. In this case, the lower contact electrodes 197a and 197b that were separated from each other by the partition 161 in the previous process may be connected to each other by the first connection wire 192a. Accordingly, the two source/drain patterns connected to the respective lower contact electrodes 197a and 197b may be connected to each other.

The second connection wire 192b may be formed within the device isolation layer 112. The second connection wire 192b may be formed to extend along the first direction D1. First, a portion of the device isolation layer 112 overlapping the connection pattern 194 and the gate contact electrode 198 in the third direction D3 may be etched to expose the lower surface of the connection pattern 194 and the lower surface of the gate contact electrode 198. Thereafter, a conductive material may be deposited in the etched region of the device isolation layer 112 to form the second connection wire 192b. The second connection wire 192b may connect the connection pattern 194 and the gate contact electrode 198 to each other.

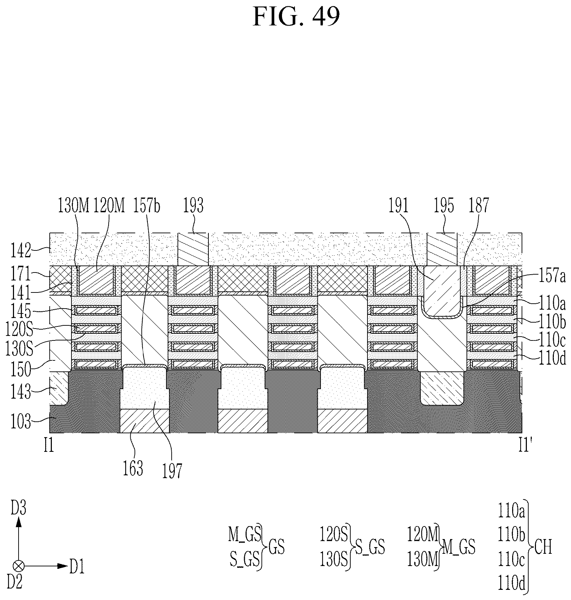

As illustrated in FIGS. 49 to 52, lower insulating patterns 164 and 165 may be formed to electrically isolate the connecting wires 192a and 192b from the power rail 220 to be formed thereafter. First, the connecting wires 192a and 192b may be etched to a predetermined depth by an etch-back process. In this case, a depth at which the connection wires 192a and 192b are etched may form an etched region that is positioned between the upper and lower surfaces of the lower insulating pattern 163. Thereafter, an insulating material may be deposited in the etched region to form the lower insulating pattern 165 positioned below the first connection wire 192a and the lower insulating pattern 164 positioned below the second connection wire 192b.

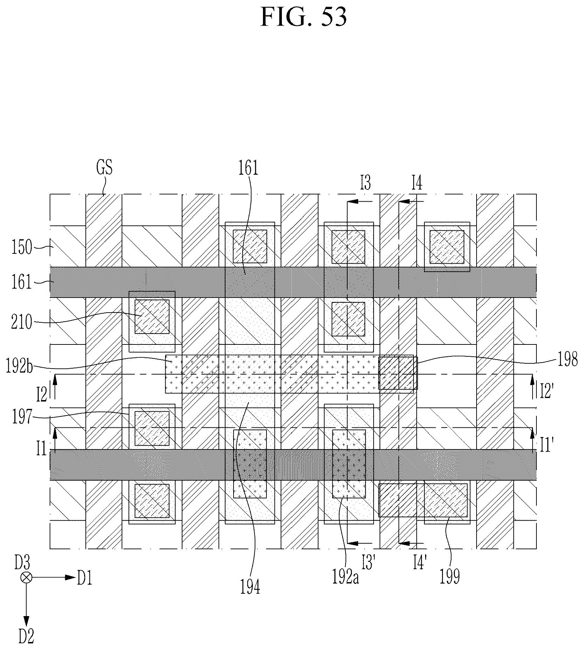

As shown in FIGS. 53 to 57, lower contact vias 210 may be formed to connect the lower contact electrode structure 197 and the power rail 220 to be formed thereafter. By means of a photo and etching process, a portion of an entire region of the lower insulating pattern 163 that overlaps the first lower contact electrode 197a or the second lower contact electrode 197b in the third direction D3 may be etched. Thereafter, a conductive material may be deposited on the etched region to form the lower contact vias 210. In an embodiment, an upper surface of the lower contact via 210 may be in contact with one of the lower contact electrodes 197a and 197b.

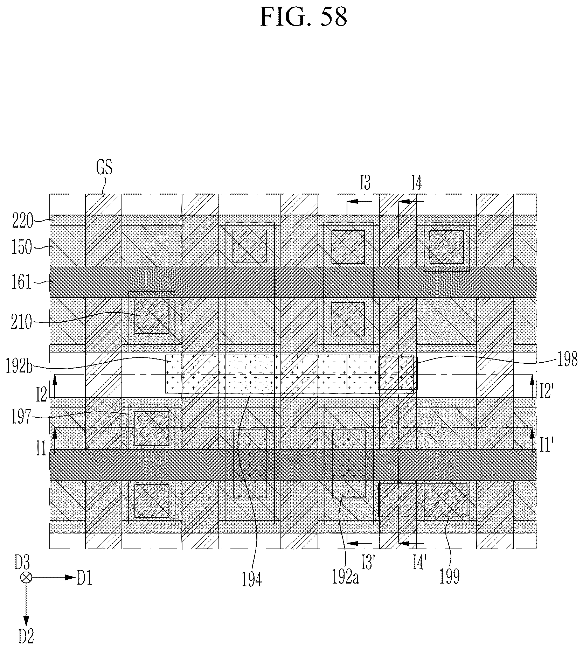

As illustrated in FIGS. 58 to 62, power rails 220 for supplying a power to a semiconductor device according to an embodiment may be formed under the base insulating pattern 103 and the device isolation layer 112. First, the lower insulating layer 167 covering an entire region of the base insulating pattern 103 and the device isolation layer 112 may be formed. Thereafter, a portion of the lower insulating layer 167 may be patterned by the photo and etching process, and then a conductive material may be deposited to form the power rails 220. In an embodiment, the connection wires 192a and 192b for transferring electrical signals between internal components of the semiconductor device may be arranged inside the device isolation layer 112 or the base insulating pattern 103, so a process margin may be secured when forming the power rail 220, thereby improving reliability of the semiconductor device. In an embodiment, a chemical mechanical polishing process may be performed to planarize the lower surface.

While this disclosure has been described in connection with what is presently considered to be practical embodiments, it is to be understood that the disclosure is not limited to the disclosed embodiments, but, on the contrary, is intended to cover various modifications and equivalent dispositions included within the scope of the appended claims.

Embodiments are set out in the following clauses:
Clause 1.A semiconductor device comprising:
   a base insulating pattern;
   a partition wall positioned on the base insulating pattern;
   a first channel structure and a second channel structure positioned apart from each other with the partition wall therebetween;
   a gate structure surrounding the first channel structure and the second channel structure;
   first source/drain patterns connected to opposite sides of the first channel structure;
   second source/drain patterns connected to opposite sides of the second channel structure and spaced apart from the first source/drain patterns with the partition wall between the first source/drain patterns and the second source/drain patterns;
   a lower contact electrode structure connected to lower portions of the first source/drain patterns and the second source/drain patterns;
   a power rail positioned below the base insulating pattern;
   a device isolation layer positioned at a first side of the first source/drain pattern or the second source/drain pattern; and
   one or more connection wires positioned within the device isolation layer and spaced apart from the power rail.
Clause 2.The semiconductor device of clause 1, wherein
   the lower contact electrode structure includes a first lower contact electrode connected to one of the first source/drain patterns, and a second lower contact electrode connected to one of the second source/drain patterns, and
   the one or more connection wires includes a first connection wire connecting the first lower contact electrode and the second lower contact electrode to each other.
Clause 3.The semiconductor device of clause 2, wherein
   the partition wall extends in a direction toward a lower surface of the base insulating pattern and extends through the lower contact electrode structure, and
   the first lower contact electrode and the second lower contact electrode are separated from each other by the partition wall.
Clause 4.The semiconductor device of any of clauses 1 to 3, wherein
   the one or more connection wires includes a second connection wire connecting at least one of the first source/drain patterns and the second source/drain patterns to the gate structure.

## Claims

1. A semiconductor device comprising:
a base insulating pattern (103);
a partition wall (161) positioned on the base insulating pattern (103);
a first channel structure (CH) and a second channel structure (CH) positioned apart from each other with the partition wall (161) therebetween;
a gate structure (GS) surrounding the first channel structure (CH) and the second channel structure (CH);
first source/drain patterns (151) connected to opposite sides of the first channel structure (CH);
second source/drain patterns (152) connected to opposite sides of the second channel structure (CH) and spaced apart from the first source/drain patterns (151) with the partition wall (161) between the first source/drain patterns (151) and the second source/drain patterns (152); and
a lower contact electrode structure (197) connected to lower portions of the first source/drain patterns (151) and the second source/drain patterns (152),
wherein the partition wall (161) extends in a direction toward a lower surface of the base insulating pattern (103) and the partition wall (161) extends through the lower contact electrode structure (197).

2. The semiconductor device of claim 1, further comprising
a power rail (220) positioned below the base insulating pattern (103),
a lower surface of the partition wall (161) positioned at a level between a level of an upper surface of the power rail (220) and a level of the lower surface of the lower contact electrode structure (197).

3. The semiconductor device of claim 2, wherein
the lower contact electrode structure (197) includes a first lower contact electrode (197a) connected to one of the first source/drain patterns (151), and a second lower contact electrode (197b) connected to one of the second source/drain patterns (152), and
the first lower contact electrode (197a) and the second lower contact electrode (197b) are separated from each other by the partition wall (161).

4. The semiconductor device of claim 3, further comprising
a lower contact via (210) connecting a lower surface of the first lower contact electrode (197a) and an upper surface of the power rail (220),
wherein a width of the lower contact via (210) in a horizontal direction is less than a width of the lower surface of the first lower contact electrode (197a) in the horizontal direction.

5. The semiconductor device of claim 4, further comprising
a first lower insulating pattern (163) positioned at a level between a level of the lower contact electrode structure (197) and a level of the power rail (220),
wherein the lower contact via (210) extends through the first lower insulating pattern (163) to connect the first lower contact electrode (197a) and the power rail (220).

6. The semiconductor device of claim 5, wherein
a portion of the partition wall (161) positioned at a level between a level of the lower surface of the lower contact electrode structure (197) and a level of the upper surface of the power rail (220) has a region that is surrounded by the first lower insulating pattern (163).

7. The semiconductor device of any of claims 3-6, further comprising:
a device isolation layer (112) positioned at a first side of the first source/drain pattern (151) or the second source/drain pattern (152); and
one or more connection wires (192a, 192b) positioned within the device isolation layer (112) and spaced apart from the power rail (220).

8. The semiconductor device of claim 7, wherein
the one or more connection wires (192a, 192b) includes a first connection wire (192a) connecting the first lower contact electrode (197a) and the second lower contact electrode (197b) to each other.

9. The semiconductor device of claim 8, wherein
a portion of the partition wall (161) positioned at a level between a level of the lower surface of the lower contact electrode structure (197) and a level of the upper surface of the power rail (220) has a region that is surrounded by the first connection wire (192a).

10. The semiconductor device of any of claims 7-9, wherein
the one or more connection wires (192a, 192b) includes a second connection wire (192b) connecting at least one of the first source/drain patterns (151) and the second source/drain patterns (152) to the gate structure (GS).

11. The semiconductor device of claim 10, further comprising
a connection pattern (194) positioned at the same level as a level of the lower contact electrode structure (197), the connection pattern (194) connecting the lower contact electrode structure (197) to another adjacent lower contact electrode structure (197).

12. The semiconductor device of claim 11, further comprising
a gate contact electrode (198) comprising a first end connected to a lower portion of the gate structure (GS) and extending into an interior of the device isolation layer (112).

13. The semiconductor device of claim 12, wherein
the second connection wire (192b) has a first end connected to the connection pattern (194) and a second end connected to the gate contact electrode (198).

14. The semiconductor device of any of claims 7-13, further comprising
a second lower insulating pattern (165) positioned between the one or more connection wires (192a, 192b) and the power rail (220).

15. The semiconductor device of any preceding claim, wherein
the partition wall (161) includes a first side surface in contact with the first source/drain patterns (151), and a second side surface in contact with the second source/drain patterns (152).
